# EUROPEAN PATENT APPLICATION

(11) **EP 1 906 247 A1**
(43) Date of publication of application: **02.04.2008**
(21) Application number: 07018102.9
(22) Date of filing: 14.09.2007
(51) Int. Cl.: G03F 7/039

(54) **Resist composition and pattern forming method using the same**

(30) Priority: 29.09.2006 JP 2006269186; 02.02.2007 JP 2007024250
(71) Applicant: FUJIFILM Corporation, Minato-ku Tokyo (JP)
(72) Inventor: Nishiyama, Fumiyuki, Haibara-gun Shizuoka (JP); Mizutani, Kazuyoshi, Haibara-gun Shizuoka (JP); Makino, Masaomi, Haibara-gun Shizuoka (JP); Sugiyama, Shinichi, Haibara-gun Shizuoka (JP)
(74) Representative: HOFFMANN EITLE

(57) **Abstract**

A resist composition, comprises: (A) a resin containing a repeating unit represented by formula (I); (B) a compound capable of generating an acid upon irradiation with actinic rays or radiation; and (C) a solvent containing: (C1) a propylene glycol monoalkyl ether carboxylate; and (C2) at least one member selected from the group consisting of a propylene glycol monoalkyl ether, an alkyl lactate, an acetic acid ester, an alkyl alkoxypropionate, a chain ketone and a cyclic ketone: 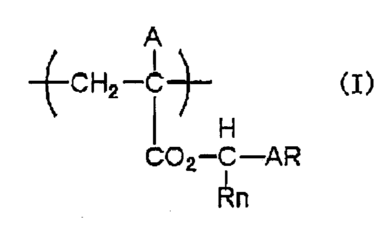 wherein AR represents a substituted or unsubstituted benzene ring or a substituted or unsubstituted naphthalene ring; Rn represents a substituted or unsubstituted alkyl group, a substituted or unsubstituted cycloalkyl group or a substituted or unsubstituted aryl group; and A represents a hydrogen atom, a substituted or unsubstituted alkyl group, a substituted or unsubstituted cycloalkyl group, a halogen atom, a cyano group or a substituted or unsubstituted alkyloxycarbonyl group, and the pattern forming method uses the same.

## Description

### Background of the Invention

### 1. Field of the Invention

The present invention relates to a positive resist composition suitable for use in the ultramicrolithography process such as production of VLSI or a high-capacity microchip or in other photofabrication processes. More specifically, the present invention relates to a positive resist composition capable of forming a high-resolution pattern by using KrF excimer laser light, electron beam, EUV light or the like, that is, a positive resist composition suitably usable for fine processing of a semiconductor device, where KrF excimer laser light, electron beam or EUV light is used, and a pattern forming method using the composition.

### 2. Description of the Related Art

In the process of producing a semiconductor device such as IC and LSI, fine processing by lithography using a photoresist composition has been conventionally performed. Recently, the integration degree of an integrated circuit is becoming higher and formation of an ultrafine pattern in the sub-micron or quarter-micron region is required. To cope with this requirement, the exposure wavelength also tends to become shorter, for example, from g line to i line or further to KrF excimer laser light: At present, other than the excimer laser light, development of lithography using electron beam, X ray or EUV light is proceeding.

At the formation of an ultrafine pattern in the sub-micron or quarter-micron region by a lithography process using KrF excimer laser light, electron beam or EUV light, the first condition is sufficiently high resolving power, but the resist film is also thinned to a sub-micron order and in the case of an ultrafine pattern in the sub-micron or quarter-micron region, even a fine defect of sub-micron order is transferred at the etching using the resist pattern as the mask and causes serious reduction in the electric characteristics, as a result, the yield decreases.

As regards the resist suitable for such a lithography process using KrF excimer laser light, electron beam or EUV light, a chemical amplification-type resist utilizing an acid catalytic reaction is mainly used from the standpoint of elevating the sensitivity and in the case of a positive resist, a chemical amplification-type resist composition mainly comprising an acid generator and a phenolic polymer which is insoluble or sparingly soluble in an alkali developer but becomes soluble in an alkali developer under the action of an acid (hereinafter simply referred to as a "phenolic acid-decomposable resin"), is being effectively used.

With respect to such a positive resist, there have been heretofore known some resist compositions using a phenolic acid-decomposable resin obtained by copolymerizing an acid-decomposable acrylate monomer having an alicyclic group as the acid-decomposable group. Examples thereof include the positive resist compositions disclosed in U.S. Patent 5,561,194 and JP-A-7-234511 (the term "JP-A" as used herein means an "unexamined published Japanese patent application").

In JP-A-7-84359, a resist comprising an alkyl lactate and a propylene glycol alkyl ether acetate as solvents is disclosed with an attempt to improve the coatability and storage stability.

However, it is not yet achieved at present to satisfy high resolution, high sensitivity and low development defect all at the same time in the ultrafine region.

### Summary of the Invention

An object of the present invention is to provide a resist composition capable of realizing high resolution, high sensitivity and reduction in the development defect after pattern formation and thereby increasing the yield in a fine processing of a semiconductor device, where actinic ray or radiation, particularly, KrF excimer laser light, electron beam or EUV light, is used, and a pattern forming method using the resist composition.

As a result of intensive studies on the resist composition, the present inventors have found that the object can be attained by using a specific phenolic acid-decomposable resin and a specific mixed solvent, and accomplished the present invention. That is, the above-described object can be attained by the following constructions.
(1) A resist composition, which comprises:
   (A) a resin containing a repeating unit represented by formula (I);
   (B) a compound capable of generating an acid upon irradiation with actinic rays or radiation; and
   (C) a solvent containing: (C1) a propylene glycol monoalkyl ether carboxylate; and (C2) at least one member selected from the group consisting of a propylene glycol monoalkyl ether, an alkyl lactate, an acetic acid ester, an alkyl alkoxypropionate, a chain ketone and a cyclic ketone: 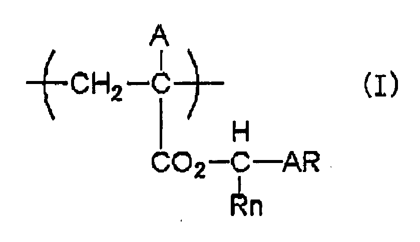
   wherein AR represents a substituted or unsubstituted benzene ring or a substituted or unsubstituted naphthalene ring;
   Rn represents a substituted or unsubstituted alkyl group, a substituted or unsubstituted cycloalkyl group or a substituted or unsubstituted aryl group; and
   A represents a hydrogen atom, a substituted or unsubstituted alkyl group, a substituted or unsubstituted cycloalkyl group, a halogen atom, a cyano group or a substituted or unsubstituted alkyloxycarbonyl group.
(2) The resist composition as described in (1) above,
   wherein the solvent (C1) is at least one member selected from the group consisting of propylene glycol monomethyl ether acetate, propylene glycol monomethyl ether propionate and propylene glycol monoethyl ether acetate.
(3) The resist composition as described in (1) or (2) above,
   wherein the solvent (C2) is at least one member selected from the group consisting of propylene glycol monomethyl ether, ethyl lactate, methoxymethyl propionate, ethoxyethyl propionate, methyl amyl ketone, cyclohexanone, γ-butyrolactone and propylene carbonate.
(4) The resist composition as described in any of (1) to (3) above,
   wherein a ratio by mass of the solvents (C1)/(C2) is from 15/85 to 90/10.
(5) The resist composition as described in any of (1) to (4) above,
   wherein the resin (A) further contains a repeating unit represented by formula (A1): 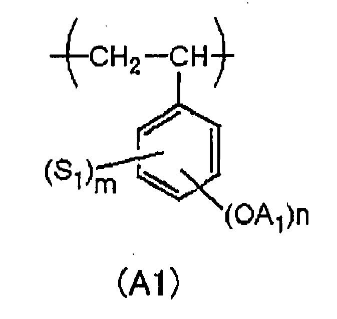 wherein n represents an integer of 0 to 3;
   m represents an integer of 0 to 3, provided that m+n≤5;
   A₁ represents a hydrogen atom or a group containing a group capable of decomposing under an action of an acid; and
   S₁ represents a substituent, and when a plurality of S₁'s are present, the plurality of S₁'s may be the same or different.
(6) The resist composition as described in any of (1) to (5) above,
   wherein in the repeating unit represented by formula (A1), the group containing a group capable of decomposing under an action of an acid represented by A₁ is an acetal group or a ketal group.
(7) The resist composition as described in any of (1) to (6) above,
   wherein AR represents a benzene or a p-methylbenzene.
(8) A pattern forming method, which comprises:
   forming a resist film from the resist composition as described in any of (1) to (7) above;and
   exposing and developing the resist film.

### Detailed Description of the Invention

The compounds for use in the present invention are described in detail below,

Incidentally, in the present invention, when a group (atomic group) is denoted without specifying whether substituted or unsubstituted, the group includes both a group having no substituent and a group having a substituent. For example, an "alkyl group" includes not only an alkyl group having no substituent (unsubstituted alkyl group) but also an alkyl group having a substituent (substituted alkyl group).

The resist composition of the present invention comprises (A) a resin containing a repeating unit represented by formula (I), (B) a compound capable of generating an acid upon irradiation with actinic rays or radiation, and (C) a specific solvent mixture.

### [1] Resin containing a repeating unit represented by formula (I)

The resist composition of the present invention comprises (A) a resin containing a repeating unit represented by formula (I).

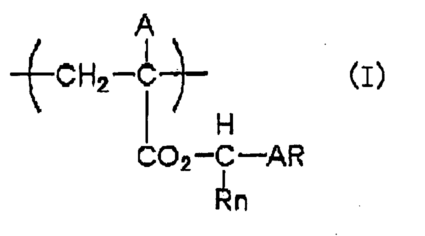

In formula (I), AR represents a benzene ring or a naphthalene ring, each of which may have one ore more substituent. As the substituent, a linear or branched alkyl group having a carbon number of 1 to 20, such as a methyl group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group, and an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue are exemplified, and a linear or branched alkyl group having a carbon number of 1 to 5 is preferred in terms of a resolving power. AR is preferably a benzene or a p-methylbenzene.

Rn represents an alkyl group, a cycloalkyl group or an aryl group.

A represents a hydrogen atom, an alkyl group, a cycloalkyl group, a halogen atom, a cyano group or an alkyloxycarbonyl group, preferably a hydrogen atom or a methyl group.

The alkyl group and cycloalkyl group in Rn are preferably an alkyl group and a cycloalkyl group each having a carbon number of 20 or less, and examples thereof include a methyl group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group. These groups each may have a substituent, and preferred examples of the substituent which these groups may have include an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. The substituent is preferably a substituent having a carbon number of 8 or less. Among those substituents, an alkoxy group, a hydroxyl group, a halogen atom, a nitro group, an acyl group, an acyloxy group, an acylamino group and a sulfonylamino group are more preferred.

The aryl group as Rn is preferably an aryl group having a carbon number of 6 to 14, and examples thereof include a phenyl group, a xylyl group, a toluyl group, a cumenyl group, a naphthyl group and an anthracenyl group.

The alkyl group and cycloalkyl group in A are preferably an alkyl group and a cycloalkyl group each having a carbon number of 20 or less, and examples thereof include a methyl group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group. These groups each may have a substituent, and preferred examples of the substituent which these groups may have include an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. A substituent having a carbon number of 8 or less is preferred. Among those substituents, a CF₃ group, an alkyloxycarbonylmethyl group, an alkylcarbonyloxymethyl group, a hydroxymethyl group and an alkoxymethyl group are more preferred.

The halogen atom in A includes a fluorine atom, a chlorine atom, a bromine atom and an iodine atom, with a fluorine atom being preferred.

Examples of the alkyl contained in the alkyloxycarbonyl group of A are the same as those of the alkyl group in A above.

Specific examples of the repeating unit represented by formula (I) are set forth below, but the present invention is not limited thereto.

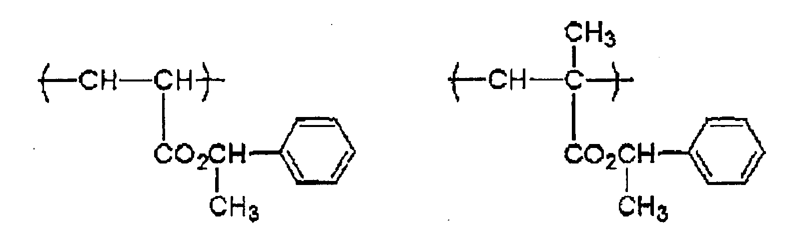

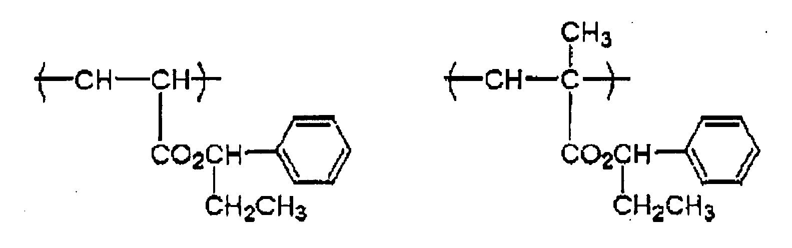

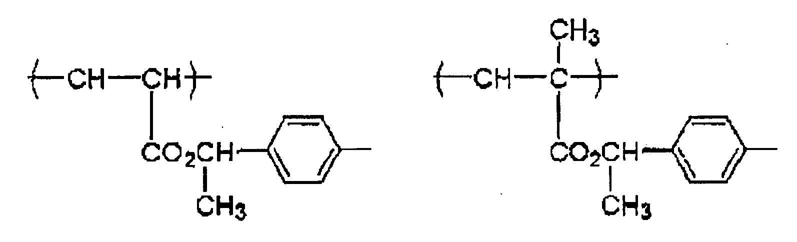

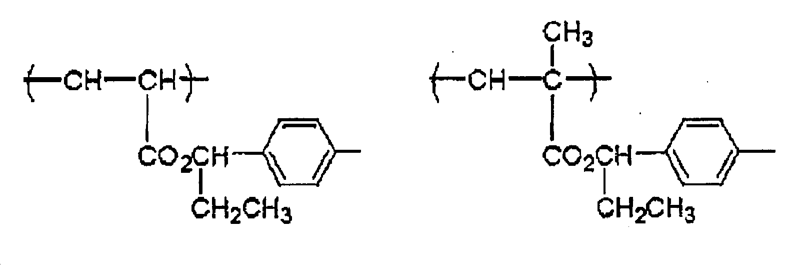

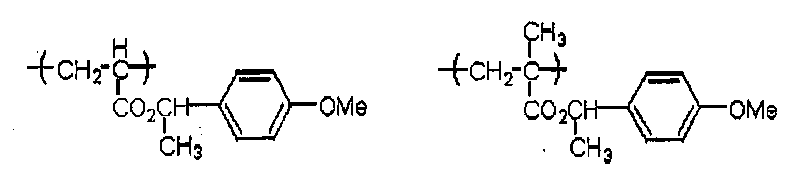

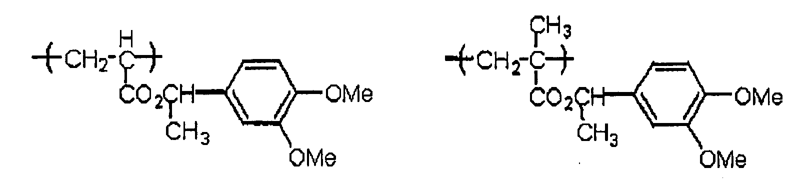

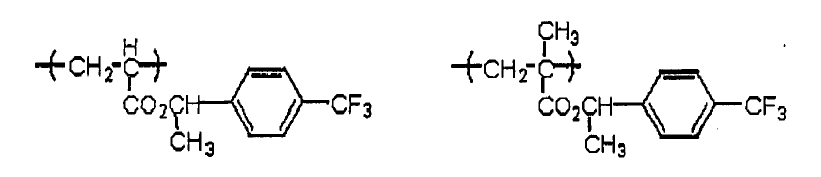

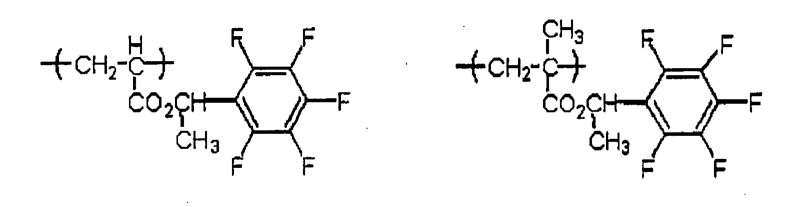

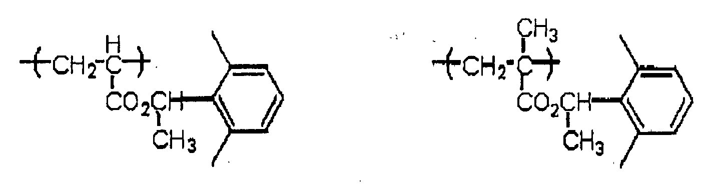

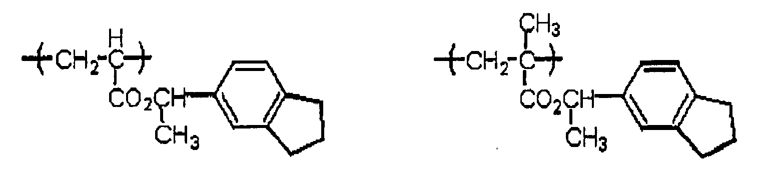

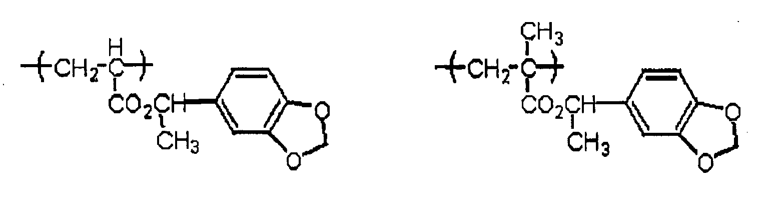

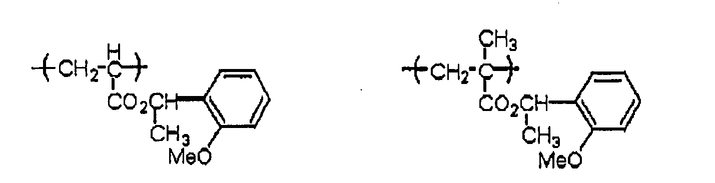

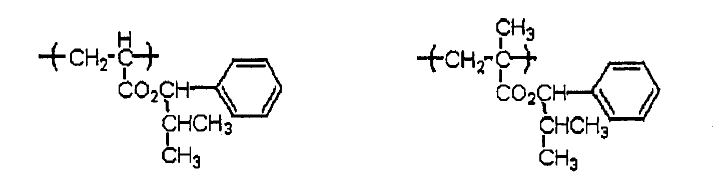

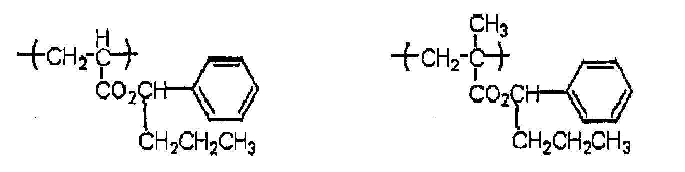

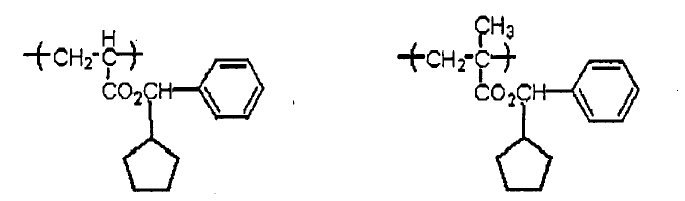

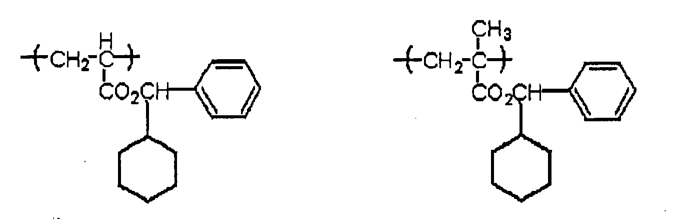

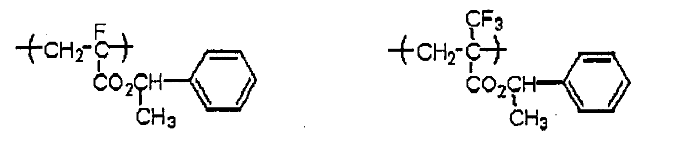

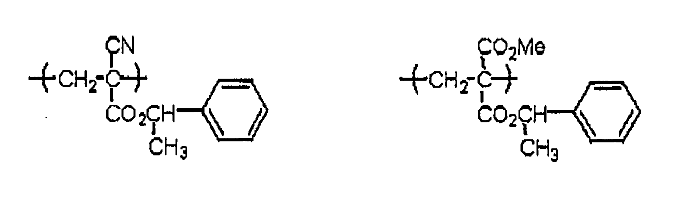

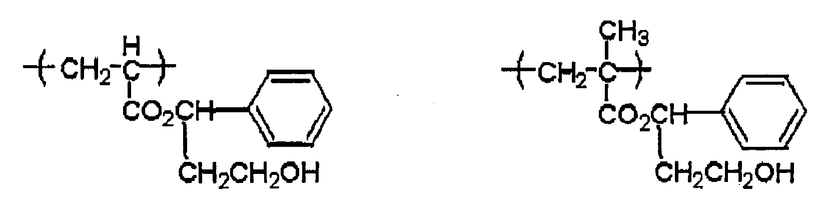

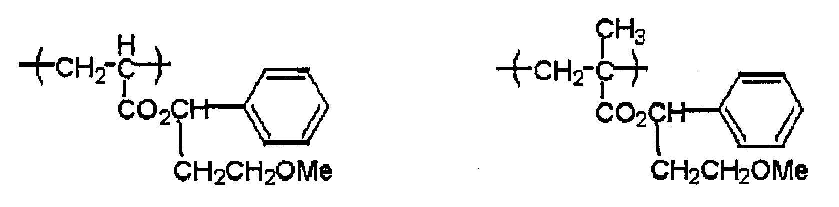

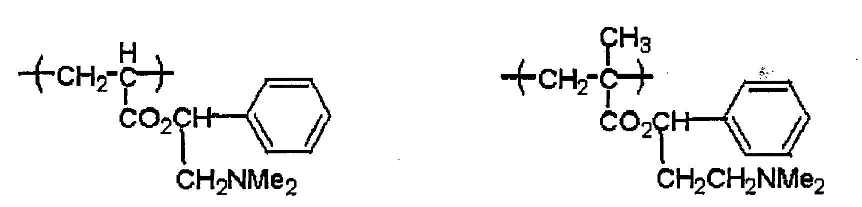

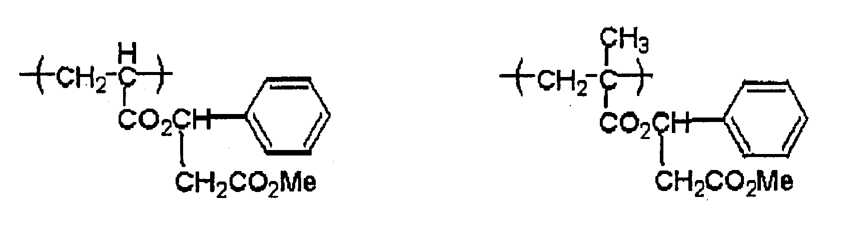

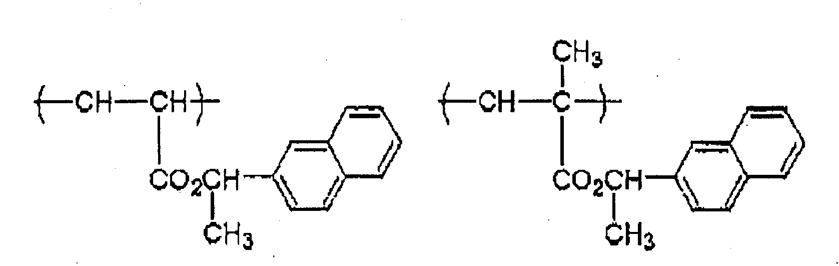

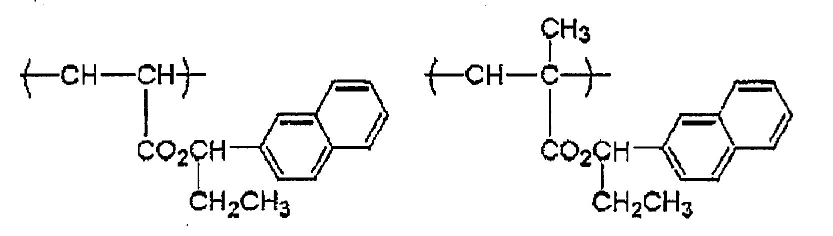

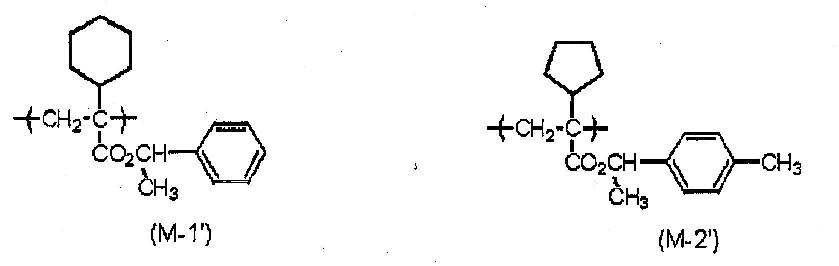

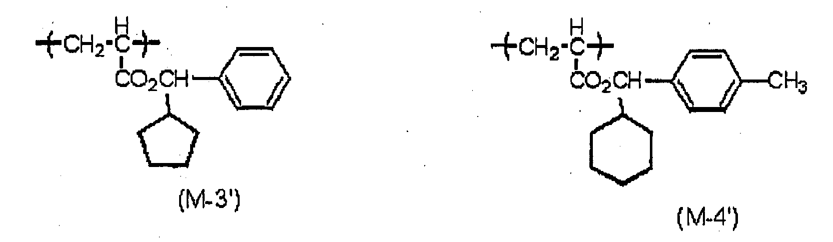

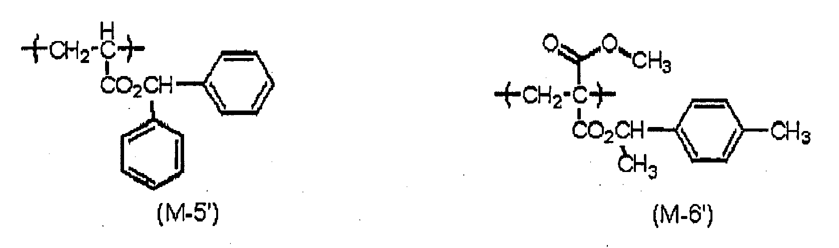

The rein (A) preferably further contains a repeating unit represented by formula (A1) or (A2).

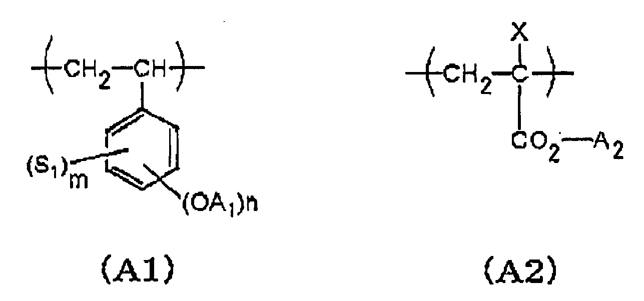

In formula (A1), n represents an integer of 0 to 3, and m represents an integer of 0 to 3, provided that m+n≤5.

A₁ represents a group containing a group capable of decomposing under the action of an acid.

Specific examples thereof include a tertiary alkyl group such as tert-butyl group and tert-amyl group, a tert-butoxycarbonyl group, a tert-butoxycarbonylmethyl group, and an acetal group or a ketal group represented by -C(L₁)(L₂)-O-Z.

L₁ and L₂, which may be the same or different, each represents a hydrogen atom, an alkyl group, a cycloalkyl group or an aralkyl group. Preferably, L₁ is a methyl group or an ethyl group, and L₂ is a hydrogen atom.

Z represents an alkyl group, a cycloalkyl group or an aralkyl group, preferably an alkyl group having a carbon number of 1 to 12 or a cycloalkyl group, more preferably an ethyl group, an isopropyl group or a cyclohexyl group.

Z and L₁ may combine with each other to form a 5- or 6-membered ring.

S₁ represents an arbitrary substituent and when a plurality of S₁'s are present, these may be the same or different. Examples thereof include an alkyl group, an alkoxy group, an acyl group, an acyloxy group, an aryl group, an aryloxy group, an aralkyl group, an aralkyloxy group, a hydroxy group, a halogen atom, a cyano group, a nitro group, a sulfonylamino group, an alkylthio group, an arylthio group and an aralkylthio group.

For example, the alkyl group or cycloalkyl group is preferably a linear or branched alkyl group or cycloalkyl group having a carbon number of 1 to 20, such as methyl group, ethyl group, propyl group, isopropyl group, n-butyl group, isobutyl group, tert-butyl group, pentyl group, cyclopentyl group, hexyl group, cyclohexyl group, octyl group and dodecyl group, and these groups each may further have a substituent.

Preferred examples of the substituent which these groups may further have include an alkyl group, an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. The substituent is preferably a substituent having a carbon number of 12 or less.

Examples of the alkyl group having a substituent include a cyclohexylethyl group, an alkylcarbonyloxymethyl group, an alkylcarbonyloxyethyl group, a cycloalkylcarbonyloxymethyl group, a cycloalkylcarbonyloxyethyl group, an arylcarbonyloxyethyl group, an aralkylcarbonyloxyethyl group, an alkyloxymethyl group, a cycloalkyloxymethyl group, an aryloxymethyl group, an aralkyloxymethyl group, an alkyloxyethyl group, a cycloalkyloxyethyl group, an aryloxyethyl group, an aralkyloxyethyl group, an alkylthiomethyl group, a cycloalkylthiomethyl group, an arylthiomethyl group, an aralkylthiomethyl group, an alkylthioethyl group, a cycloalkylthioethyl group, an arylthioethyl group and an aralkylthioethyl group.

The alkyl group or cycloalkyl group in these groups is not particularly limited and may further have the above-described substituent such as alkyl group, cycloalkyl group and alkoxy group.

Examples of the alkylcarbonyloxyethyl group and cycloalkylcarbonyloxyethyl group include a cyclohexylcarbonyloxyethyl group, a tert-butylcyclohexylcarbonyloxyethyl group and an n-butylcyclohexylcarbonyloxyethyl group.

The aryl group is also not particularly limited but generally includes an aryl group having a carbon number of 6 to 14, such as phenyl group, xylyl group, toluyl group, cumenyl group, naphthyl group and anthracenyl group, and the aryl group may have the above-described substituent such as alkyl group, cycloalkyl group and alkoxy group.

Examples of the aryloxyethyl group include a phenyloxyethyl group and a cyclohexylphenyloxyethyl group. These groups each may further have a substituent.

The aralkyl is also not particularly limited but examples thereof include a benzyl group.

Examples of the aralkylcarbonyloxyethyl group include a benzylcarbonyloxyethyl group. This group may further have a substituent.

Examples of the aralkyl group in L₁, L₂ and Z include an aralkyl group having a carbon number of 7 to 15, such as benzyl group and phenethyl group. These groups each may have a substituent.

Preferred examples of the substituent which the aralkyl group has include an alkoxy group, a hydroxyl group, a halogen atom, a nitro group, an acyl group, an acylamino group, a sulfonylamino group, an alkylthio group, an arylthio group and an aralkylthio group. Examples of the aralkyl group having a substituent include an alkoxybenzyl group, a hydroxybenzyl group and a phenylthiophenethyl group.

The carbon number of the substituent which the aralkyl group in L₁, L₂ or Z may have is preferably 12 or less.

Examples of the 5- or 6-membered ring formed resulting from Z and L₁ combining with each other include a tetrahydropyran ring and a tetrahydrofuran ring.

In the present invention, Z is preferably a linear or branched alkyl group. By virtue of this, the effects of the present invention are more successfully brought out.

In formula (A2), A₂ represents a group capable of decomposing under the action of an acid or a group containing a group capable of decomposing under the action of an acid.

X represents a hydrogen atom, an alkyl group, a cycloalkyl group, a halogen atom, a cyano group or an alkyloxycarbonyl group, and details thereof are the same as those of A in formula (I).

A₂ is preferably a hydrocarbon group (preferably having a carbon number of 20 or less, more preferably from 4 to 12), more preferably a tert-butyl group, a tert-amyl group or an alicyclic structure-containing hydrocarbon group (for example, an alicyclic group itself or a group where an alicyclic group is substituted to an alkyl group).

The alicylcic structure may be either monocyclic or polycyclic. Specific examples thereof include a monocyclo, bicyclo, tricyclo or tetracyclo structure having a carbon number of 5 or more. The carbon number is preferably from 6 to 30, more preferably from 7 to 25. The alicyclic structure-containing hydrocarbon group may have a substituent.

Examples of the alicyclic structure are set forth below.

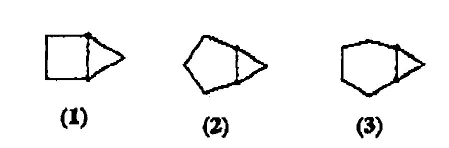

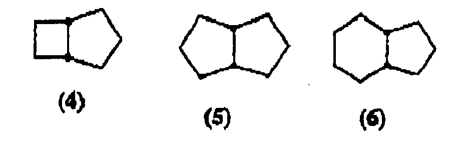

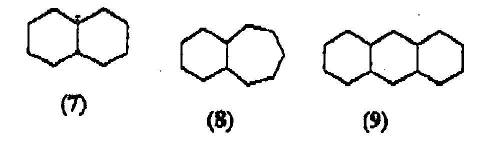

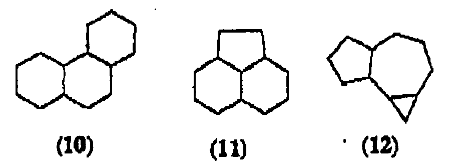

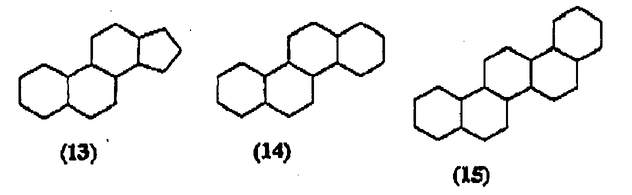

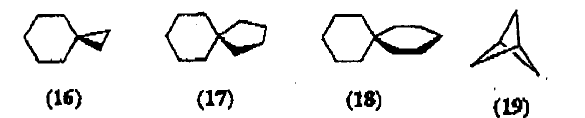

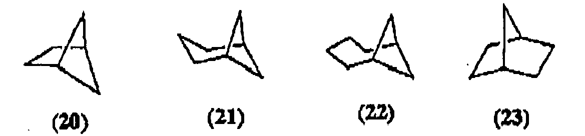

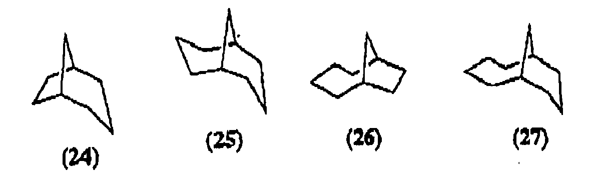

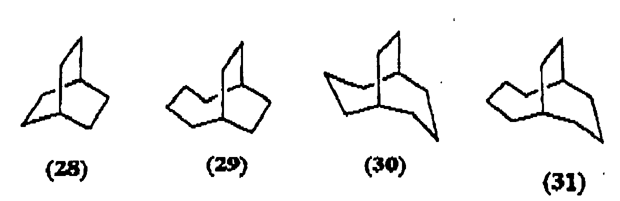

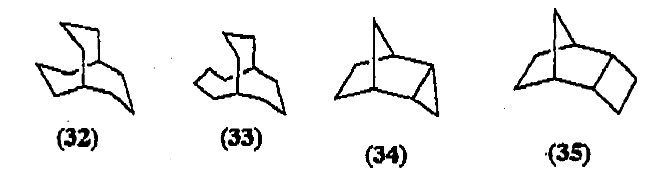

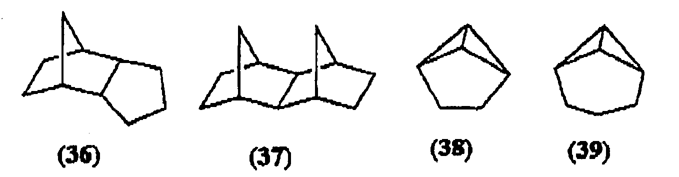

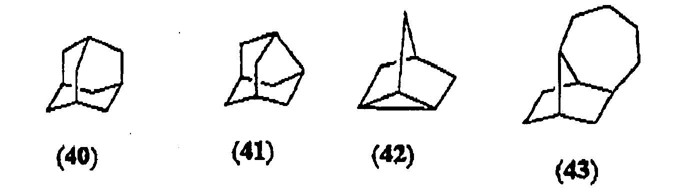

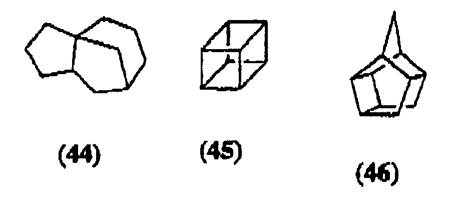

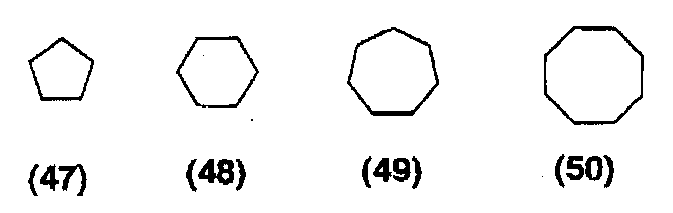

In the present invention, among these alicyclic structures, as denoted in terms of the monovalent alicyclic group, preferred are an adamantyl group, a noradamantyl group, a decalin residue, a tricyclodecanyl group, a tetracyclododecanyl group, a norbornyl group, a cedrol group, a cyclohexyl group, a cycloheptyl group, a cyclooctyl group, a cyclodecanyl group and a cyclododecanyl group, more preferred are an adamantyl group, a decalin residue, a norbornyl group, a cedrol group, a cyclohexyl group, a cycloheptyl group, a cyclooctyl group, a cyclodecanyl group and a cyclododecanyl group.

Examples of the substituent which the alicyclic ring in these structures may have include an alkyl group, a halogen atom, a hydroxyl group, an alkoxy group, a carboxyl group and an alkoxycarbonyl group. The alkyl group is preferably a lower alkyl group such as methyl group, ethyl group, propyl group, isopropyl group and butyl group, more preferably a methyl group, an ethyl group, a propyl group or an isopropyl group, The alkoxy group includes an alkoxy group having a carbon number of 1 to 4, such as methoxy group, ethoxy group, propoxy group and butoxy group. The alkyl group and alkoxy group each may further have a substituent, and examples of the substituent which the alkyl group and alkoxy group may further have include a hydroxyl group, a halogen atom and an alkoxy group.

The acid-decomposable group having an alicyclic structure is preferably a group represented by any one of the following formulae (pI) to (pV):

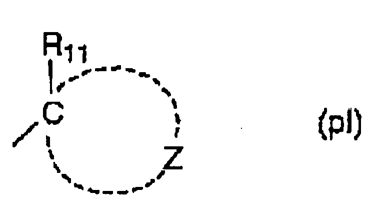

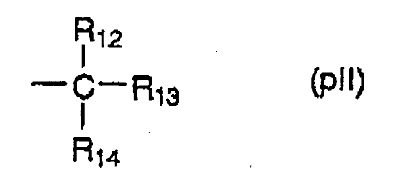

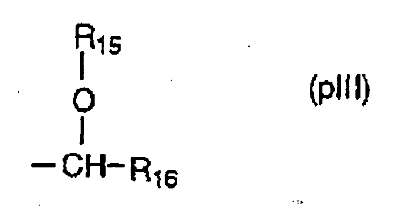

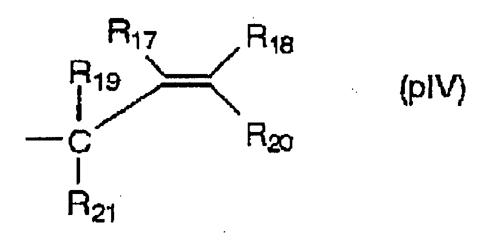

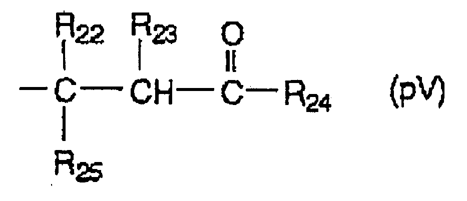

In formulae (pI) to (pV), R₁₁ represents a methyl group, an ethyl group, an n-propyl group, an isopropyl group, an n-butyl group, an isobutyl group or a sec-butyl group. Z represents an atomic group necessary for forming an alicyclic hydrocarbon group together with the carbon atom,

R₁₂ to R₁₆ each independently represents a linear or branched alkyl group having a carbon number of 1 to 4 or an alicyclic hydrocarbon group, provided that at least one of R₁₂ to R₁₄ or either one of R₁₅ and R₁₆ represents an alicyclic hydrocarbon group.

R₁₇ to R₂₁ each independently represents a hydrogen atom, a linear or branched alkyl group having a carbon number of 1 to 4 or an alicyclic hydrocarbon group, provided that at least one of R₁₇ to R₂₁ represents an alicyclic hydrocarbon group. Also, either one of R₁₉ and R₂₁ represents a linear or branched alkyl group having a carbon number of 1 to 4 or an alicyclic hydrocarbon group.

R₂₂ to R₂₅ each independently represents a hydrogen atom, a linear or branched alkyl group having a carbon number of I to 4 or an alicyclic hydrocarbon group, provided that at least one of R₂₂ to R₂₅ represents an alicyclic hydrocarbon group. Also, R₂₃ and R₂₄ may combine with each other to form a ring.

In formulae (pI) to (pV), the alkyl group of R₁₂ to R₂₅ is a linear or branched alkyl group having from 1 to 4 carbon atoms, which may be substituted or unsubstituted, and examples of the alkyl group include a methyl group, an ethyl group, an n-propyl group, an isopropyl group, an n-butyl group, an isobutyl group, a sec-butyl group and a tert-butyl group.

Examples of the substituent which the alkyl group may further have include an alkoxy group having a carbon number of 1 to 4, a halogen atom (e,g., fluorine, chlorine, bromine, iodine), an acyl group, an acyloxy group, a cyano group, a hydroxyl group, a carboxy group, an alkoxycarbonyl group and a nitro group.

Examples of the alicyclic hydrocarbon group of R₁₁ to R₂₅ and the alicyclic hydrocarbon group formed by Z together with the carbon atom include those described above for the alicyclic structure.

Specific examples of the alicyclic structure-containing group capable of decomposing under the action of an acid or the group containing a group capable of decomposing under the action of an acid (acid-decomposable group), represented by A₂, are set forth below.

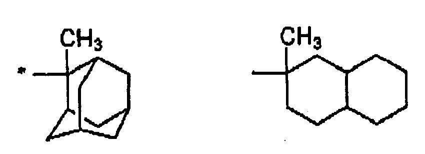

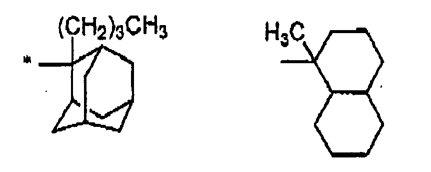

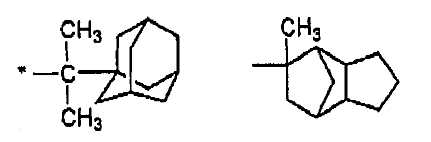

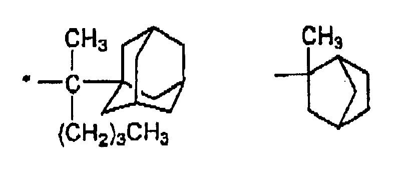

In the present invention, the group containing a group capable of decomposing under the action of an acid may be a group where as a result of desorption of A₁ or A₂, a hydroxyl group or a carboxyl group is produced in the repeating unit represented by formula (A1) or (A2), that is, a group capable of decomposing under the action of an acid (an acid-decomposable group) itself, or may be a group containing an acid-decomposable group, that is, a group where as a result of decomposition under the action of an acid, an alkali-soluble group such as hydroxyl group or carboxyl group is produced in the residue bonded to the repeating unit.

The monomer corresponding to the repeating unit represented by formula (I) or (A2) may be synthesized by esterifying a (meth)acrylic acid chloride and an alcohol compound in a solvent such as THF, acetone and methylene chloride in the presence of a basic catalyst such as triethylamine, pyridine and DBU. A commercially available product may also be used.

The monomer corresponding to the repeating unit represented by formula (A1) may be synthesized by acetalizing a hydroxy-substituted styrene monomer and a vinyl ether compound in a solvent such as THF and methylene chloride in the presence of an acidic catalyst such as p-toluenesulfonic acid and pyridine p-toluenesulfonate, or by effecting t-Boc protection with use of tert-butyl dicarboxylate in the presence of a basic catalyst such as triethylamine, pyridine and DBU. A commercially available product may also be used.

Specific examples of the repeating unit represented by formula (A1) are set forth below, but the present invention is not limited thereto.

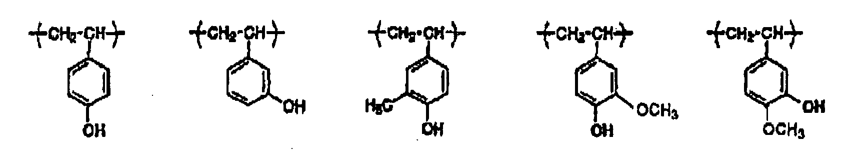

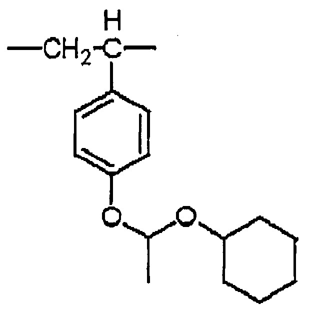

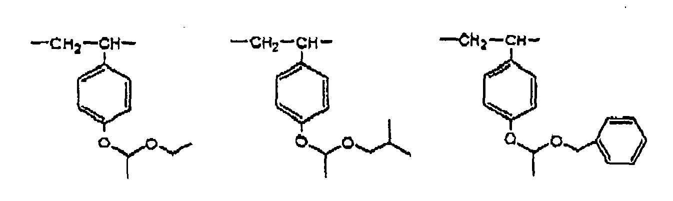

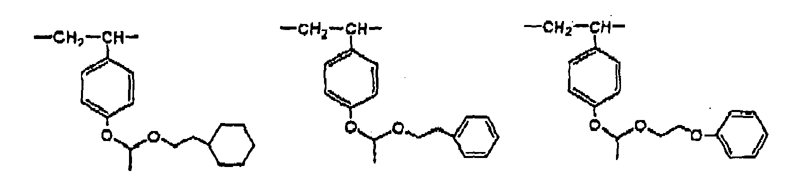

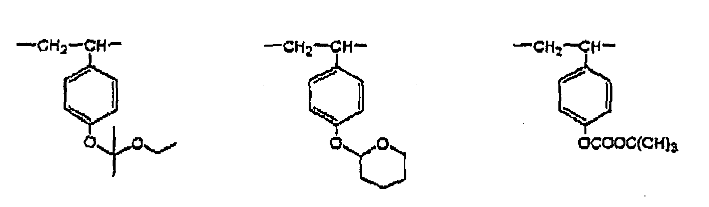

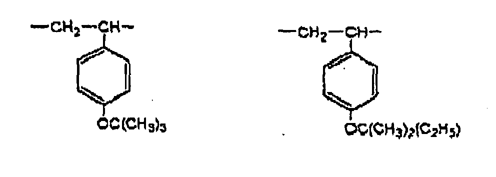

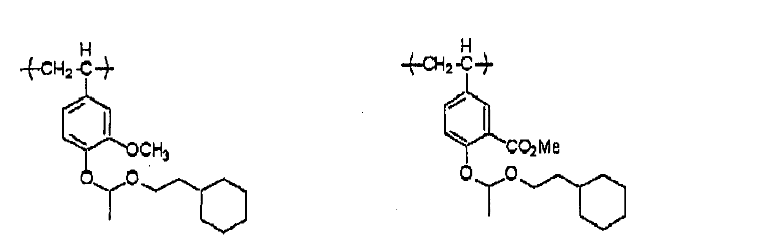

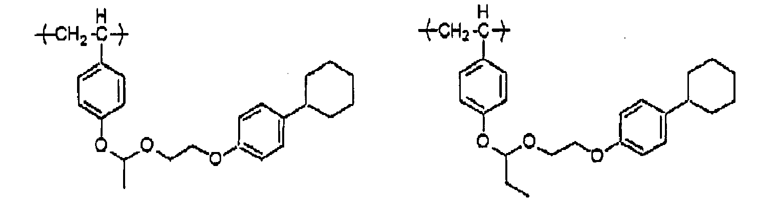

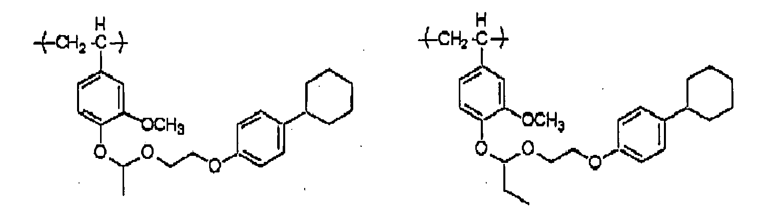

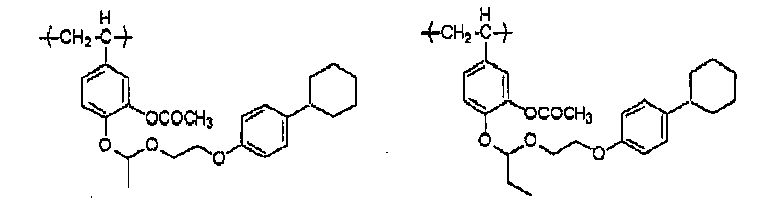

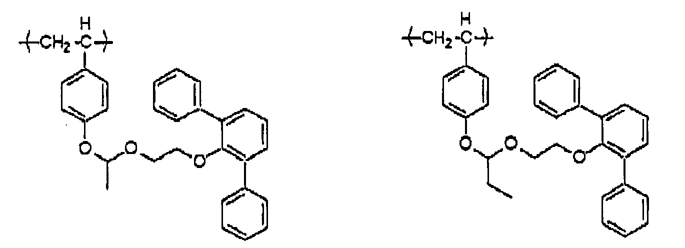

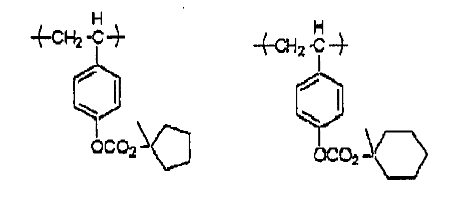

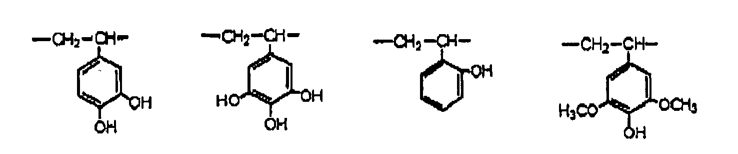

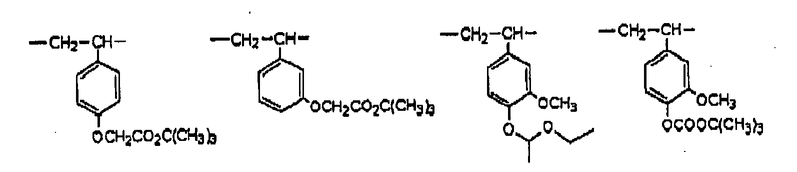

Specific examples of the repeating unit represented by formula (A2) are set forth below, but the present invention is not limited thereto.

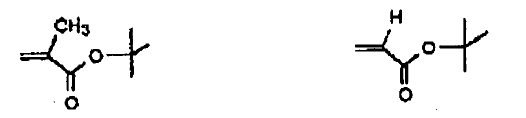

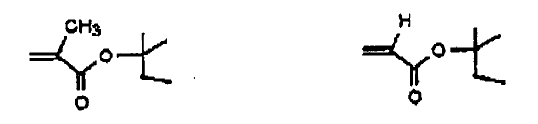

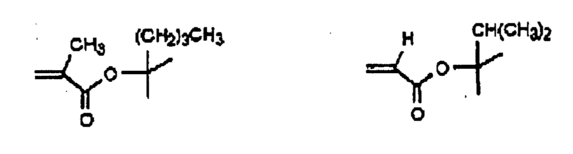

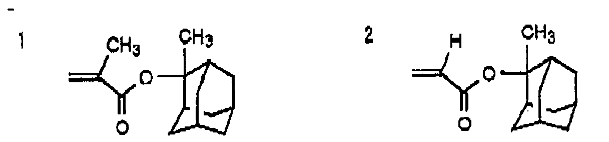

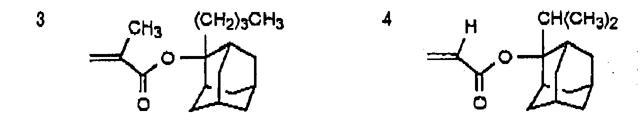

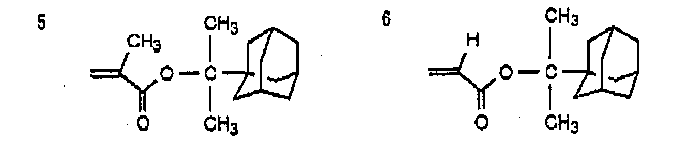

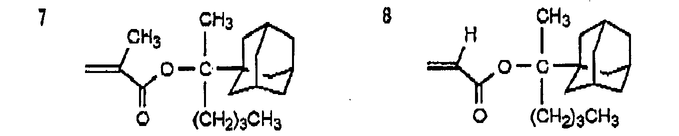

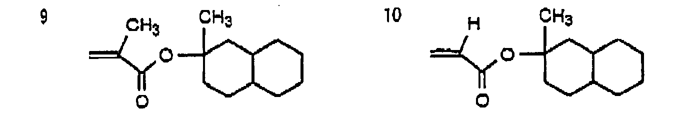

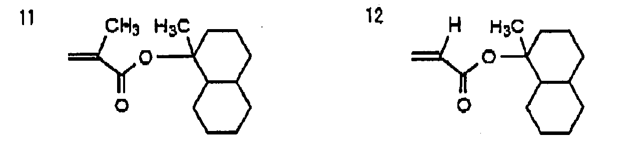

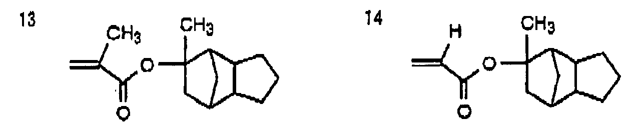

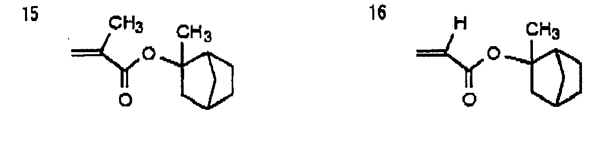

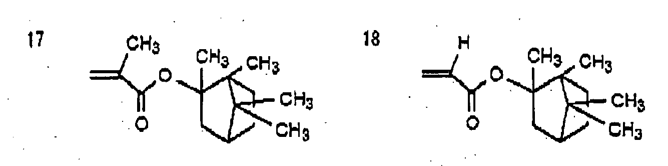

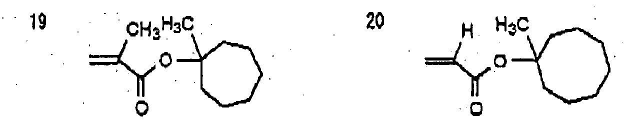

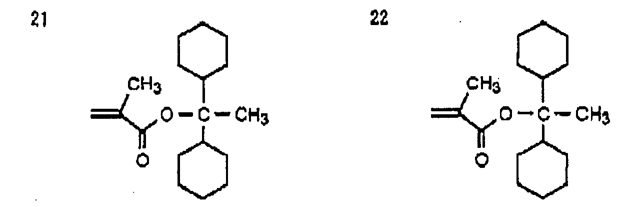

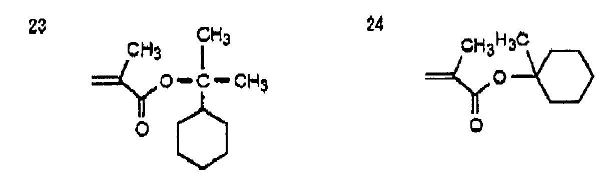

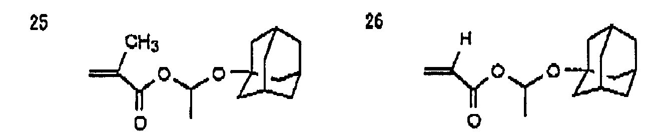

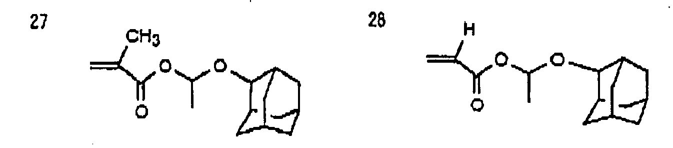

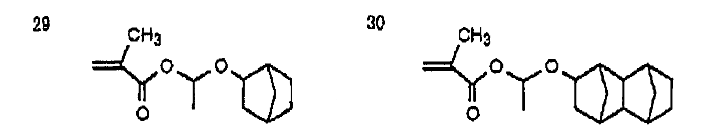

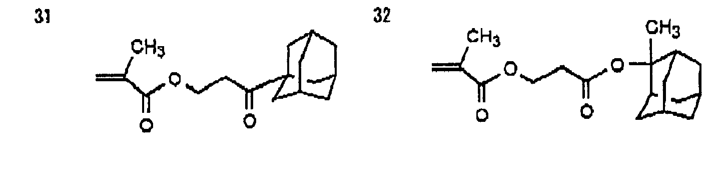

The resin (A) preferably further contains a repeating unit represented by formula (A4).

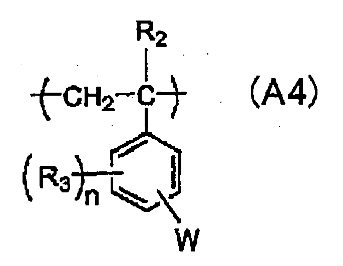

In formula (A4), R₂ represents a hydrogen atom, a methyl group, a cyano group, a halogen atom or a perfluoro group (preferably having a carbon number of 1 to 4).

R₃ represents a hydrogen atom, an alkyl group, a cycloalkyl group, a halogen atom, an aryl group, an alkoxy group or an acyl group.

n represents an integer of 0 to 4.

W represents a group incapable of decomposing under the action of an acid.

W represents a group incapable of decomposing under the action of an acid (sometimes referred to as an "acid-stable group"), and specific examples thereof include a hydrogen atom, a halogen atom, an alkyl group, a cycloalkyl group, an alkenyl group, an aryl group, an acyl group, an alkylamido group, an arylamidomethyl group and an arylamido group. The acid-stable group is preferably an acyl group or an alkylamido group, more preferably an acyl group, an alkylcarbonyloxy group, an alkyloxy group, a cycloalkyloxy group or an aryloxy group.

In the acid-stable group represented by W, the alkyl group is preferably an alkyl group having a carbon number of 1 to 4, such as methyl group, ethyl group, propyl group, n-butyl group, sec-butyl group and tert-butyl group; the cycloalkyl group is preferably a cycloalkyl group having a carbon number of 3 to 10, such as cyclopropyl group, cyclobutyl group, cyclohexyl group and adamantyl group; the alkenyl group is preferably an alkenyl group having a carbon number of 2 to 4, such as vinyl group, propenyl group, allyl group and butenyl group; the alkenyl group is preferably an alkenyl group having a carbon number of 2 to 4, such as vinyl group, propenyl group, allyl group and butenyl group; and the aryl group is preferably an aryl group having a carbon number of 6 to 14, such as phenyl group, xylyl group, toluyl group, cumenyl group, naphthyl group and anthracenyl group. W may be present at any position on the benzene ring but is preferably present at the meta-position or para-position, more preferably at the para-position, of the styrene skeleton.

Specific examples of the repeating unit represented by formula (A4) are set forth below, but the present invention is not limited thereto.

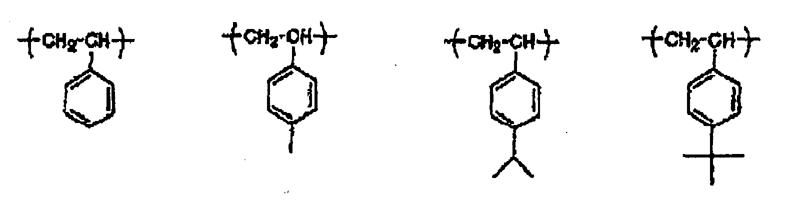

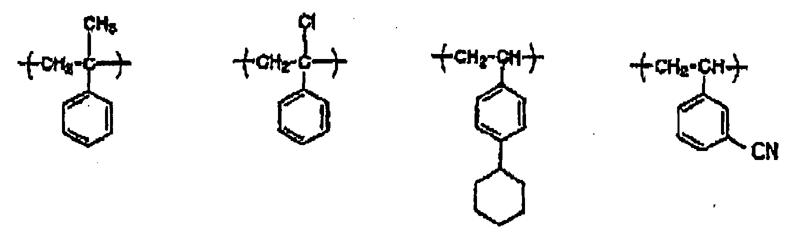

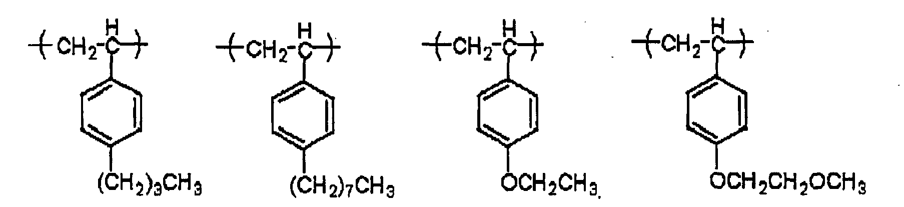

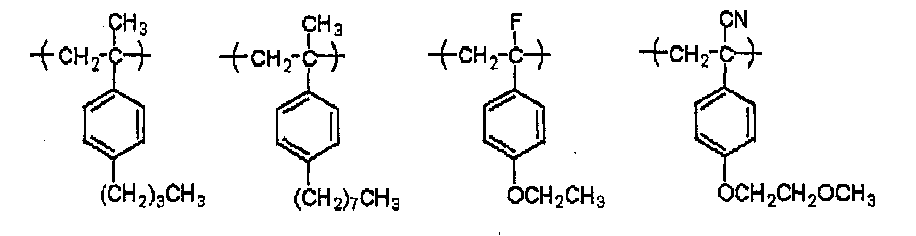

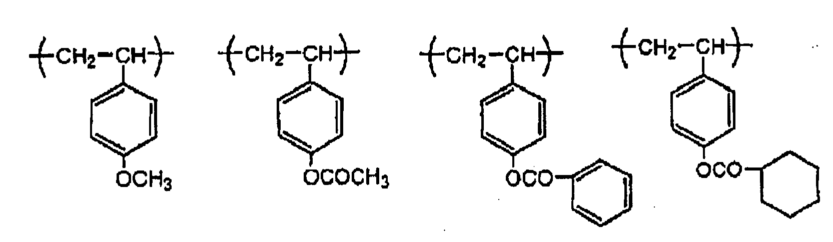

The resin (A) preferably further contains a repeating unit comprising a (meth)acrylic acid derivative incapable of decomposing under the action of an acid. Specific examples thereof are set forth below, but the present invention is not limited thereto.

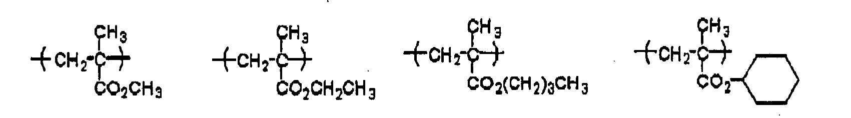

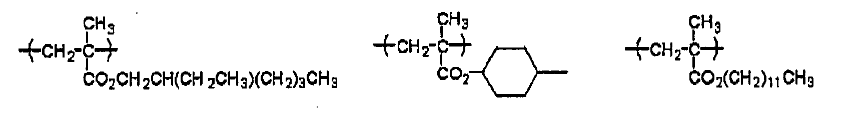

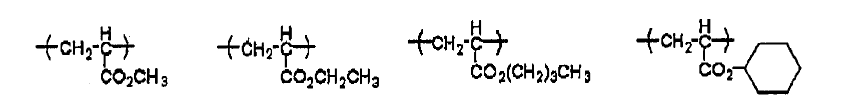

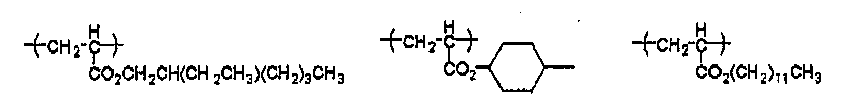

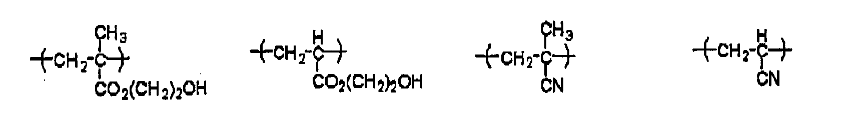

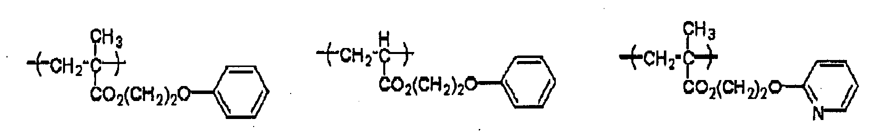

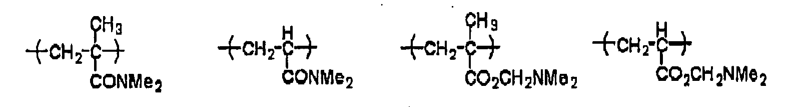

The resin (A) is a resin which contains a repeating unit represented by formula (I) capable of producing a carboxyl group of the side chain under the action of an acid and of which solubility in an alkali developer increases under the action of an acid (acid-decomposable resin), and preferably contains a group capable of decomposing under the action of an acid to produce an alkali-soluble group (acid-decomposable group), in an arbitrary repeating unit.

The acid-decomposable group may be contained also in other repeating units such as repeating unit represented by formula (A1) or (A2).

Examples of the acid-decomposable group include, in addition to those described above, a group represented by -C(=O)-X₁-R₀.

In the formula above, R₀ represents, for example, a tertiary alkyl group such as tert-butyl group and tert-amyl group, an isobornyl group, a 1-alkoxyethyl group such as 1-ethoxyethyl group, 1-butoxyethyl group, 1-isobutoxyethyl group and 1-cyclohexyloxyethyl group, an alkoxymethyl group such as 1-methoxymethyl group and 1-ethoxymethyl group, a 3-oxoalkyl group, a tetrahydropyranyl group, a tetrahydrofuranyl group, a trialkylsilyl ester group, a 3-oxocyclohexyl ester group, a 2-methyl-2-adamantyl group, or a mevalonic lactone residue. X₁ represents an oxygen atom, a sulfur atom, -NH-, -NHSO₂- or -NHSO₂NH-.

The content of the acid-decomposable group-containing repeating unit in the resin (A) is preferably from 1 to 50 mol%, more preferably from 3 to 40 mol%, still more preferably from 5 to 3 5 mol%, based on all repeating units.

The content of the repeating unit represented by formula (I) in the resin (A) is preferably from 10 to 60 mol%, more preferably from 15 to 50 mol%, still more preferably from 20 to 40 mol%, based on all repeating units.

The content of the repeating unit represented by formula (A1) in the resin (A) is preferably from 40 to 90 mol%, more preferably from 50 to 85 mol%, still more preferably from 60 to 80 mol%, based on all repeating units.

The content of the repeating unit represented by formula (A2) in the resin (A) is preferably from 5 to 60 mol%, more preferably from 10 to 50 mol%, still more preferably from 15 to 35 mol%, based on all repeating units.

The resin (A) may further contain a repeating unit represented by formula (A4), and this is preferred from the standpoint of, for example, enhancing the film quality or suppressing the film loss in the unexposed area. The content of the repeating unit represented by formula (A4) is preferably from 0 to 50 mol%, more preferably from 0 to 40 mol%, still more preferably from 0 to 30 mol%, based on all repeating units.

In the resin (A), other appropriate polymerizable monomers may be copolymerized to introduce an alkali-soluble group such as phenolic hydroxyl group or carboxyl group for maintaining good developability with an alkali developer, or other hydrophobic polymerizable monomers such as alkyl acrylate or alkyl methacrylate may be copolymerized for enhancing the film quality.

The weight average molecular weight (Mw) of the resin (A) is preferably from 1,000 to 15,000, more preferably from 3,000 to 12,000. The dispersity (Mw/Mn) is preferably from 1.0 to 2.0, more preferably from 1.0 to 1.8, still more preferably from 1.0 to 1.7.

The weight average molecular weight here is defined as a polystyrene-reduced value determined by gel permeation chromatography.

The resin (A) having a dispersity of 1.5 to 2.0 can be synthesized by radical polymerization using an azo-based polymerization initiator. Also, the resin (A) having a still more preferred dispersity of 1.0 to 1.7 can be synthesized by living radical polymerization.

Two or more species of the resin (A) may be used in combination.

The amount of the resin (A) added is, as the total amount, usually from 10 to 96 mass%, preferably from 15 to 96 mass%, more preferably from 20 to 95 mass%, based on the entire solid content of the positive resist composition. (In this specification, mass ratio is equal to weight ratio.)

Specific examples of the resin (A) are set forth below, but the present invention is not limited thereto.

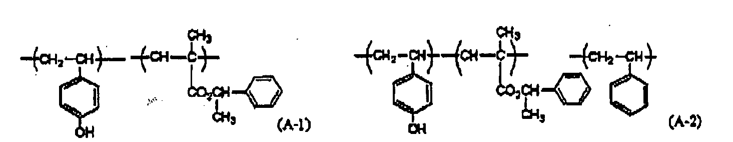

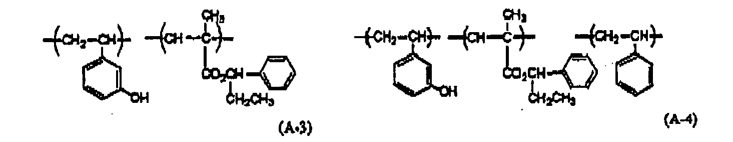

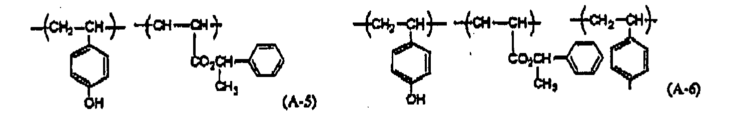

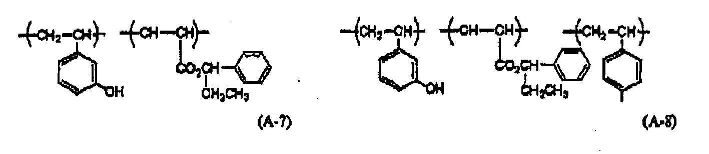

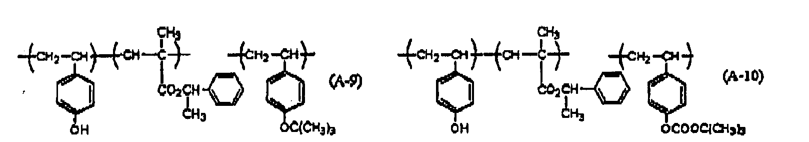

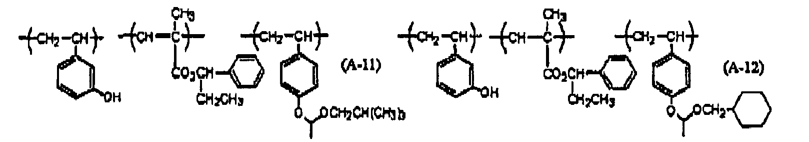

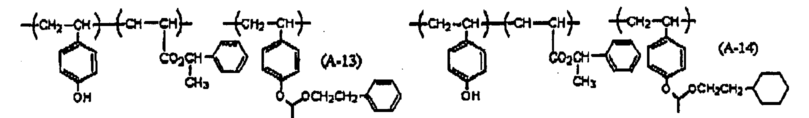

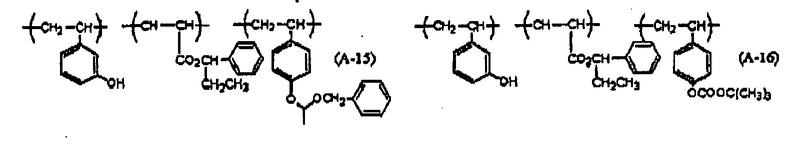

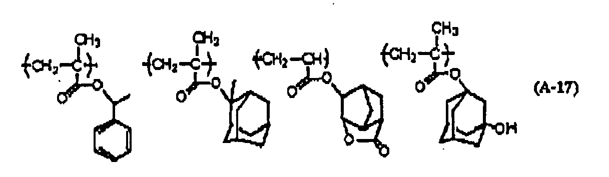

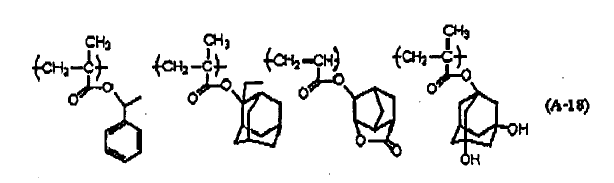

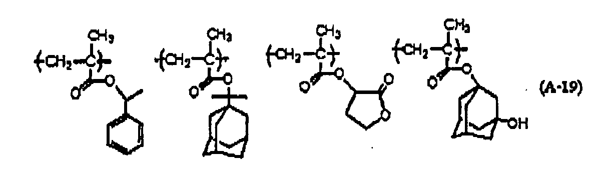

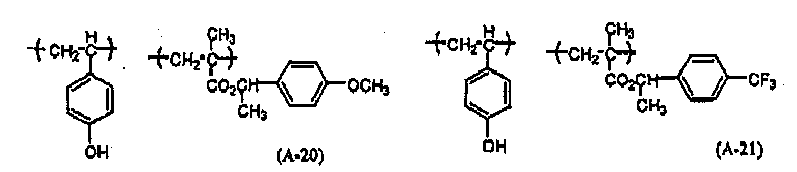

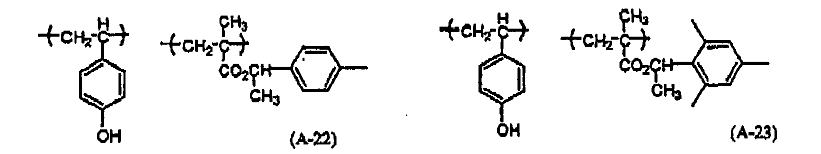

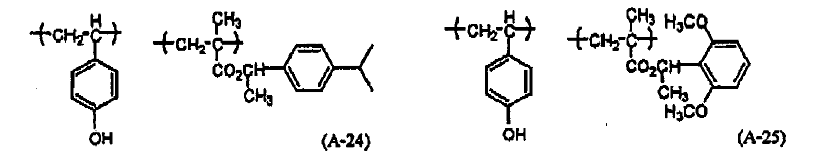

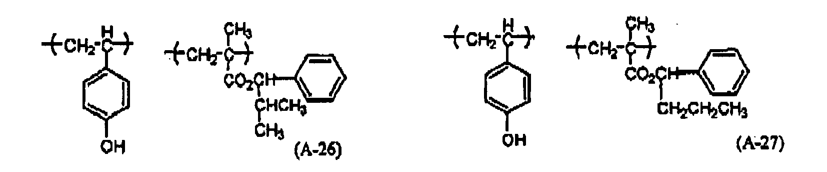

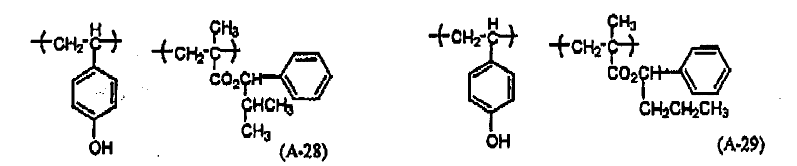

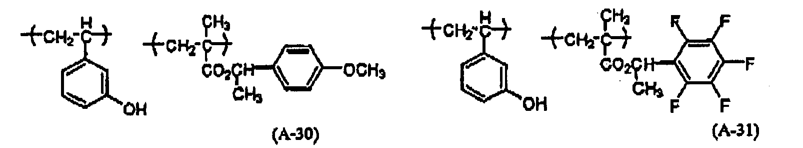

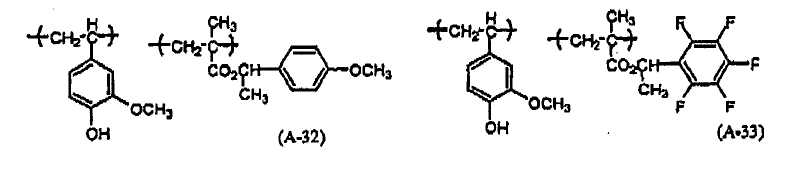

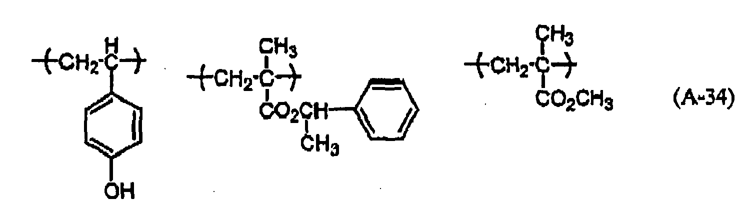

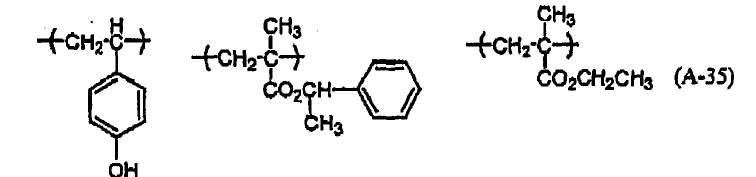

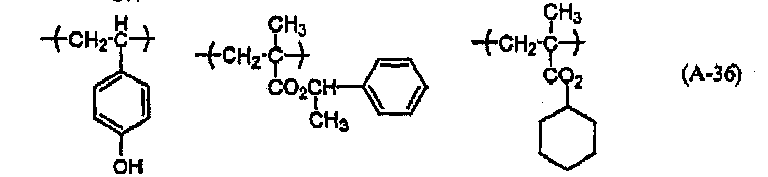

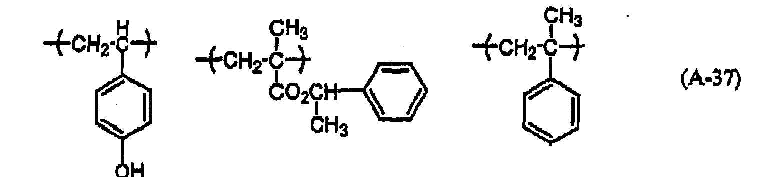

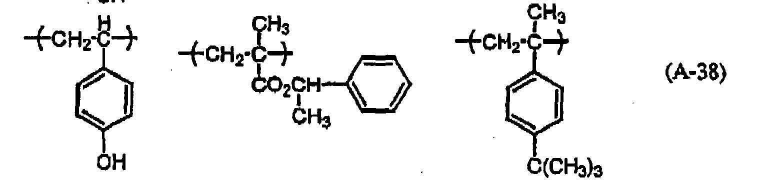

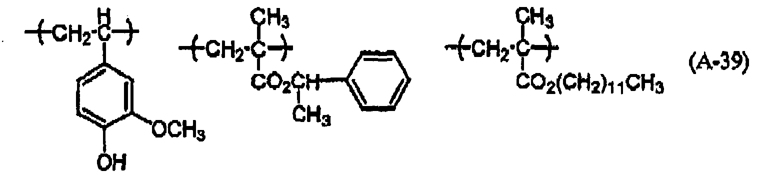

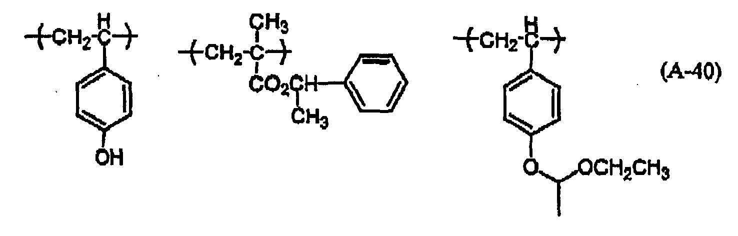

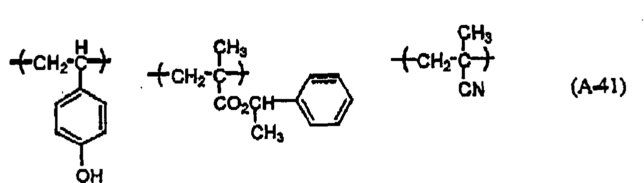

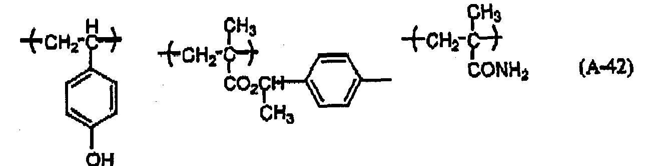

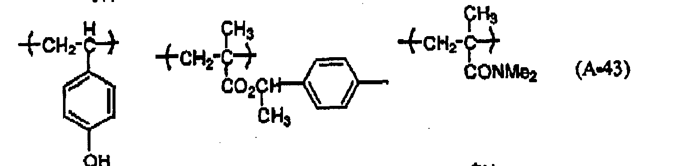

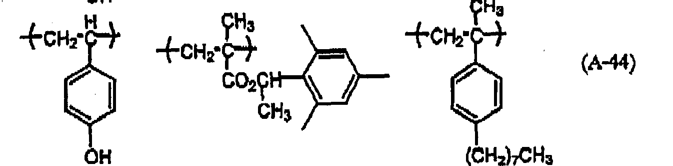

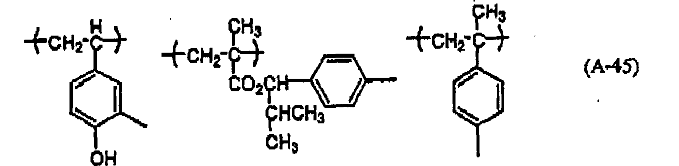

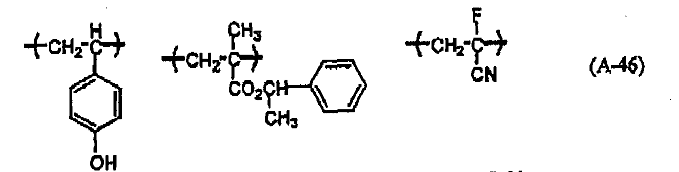

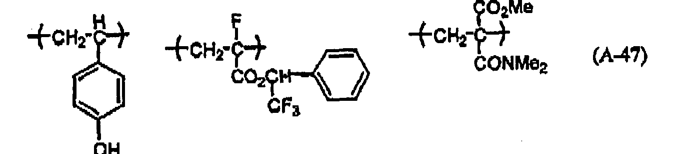

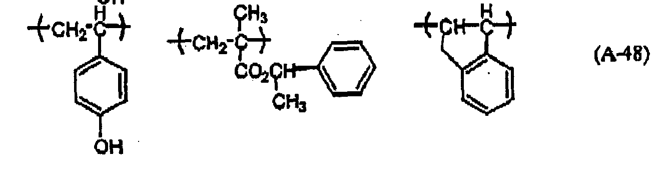

In the case of irradiating KrF excimer laser light, electron beam, X ray or high-energy beam at a wavelength of 50 nm or less (e.g., EUV), the positive photosensitive composition of the present invention preferably contains a hydroxystyrene copolymer protected by hydroxystyrene/acid-decomposable group, or a hydroxystyrene/tertiary alkyl (meth)acrylate copolymer.

Specific examples thereof are set forth below, but the present invention is not limited thereto.

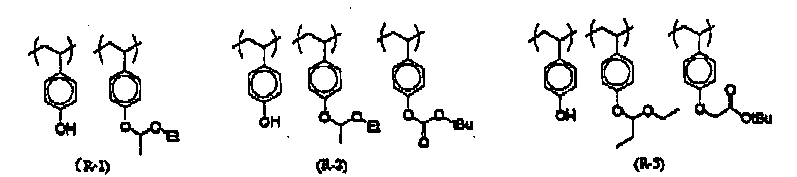

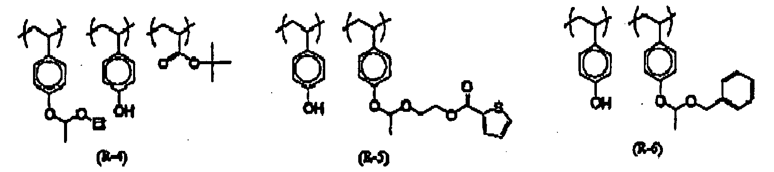

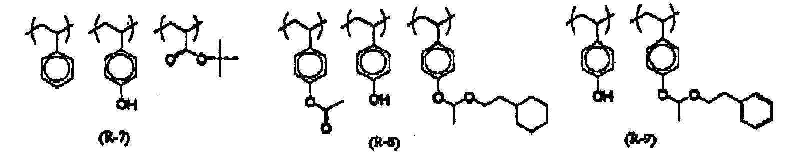

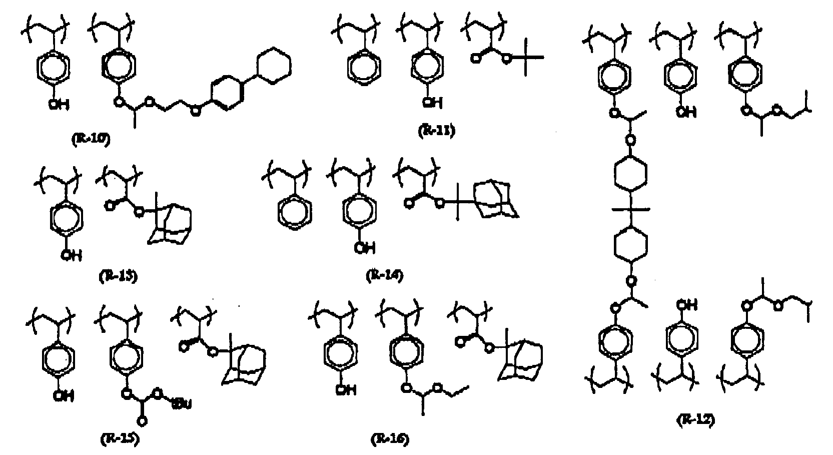

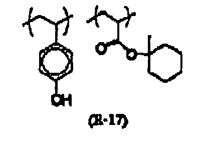

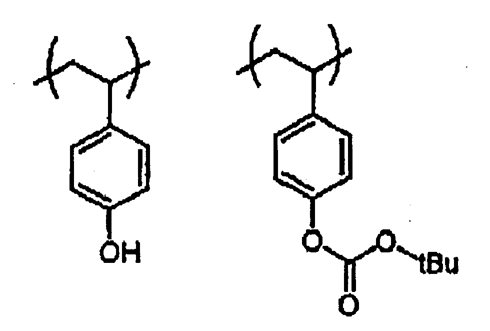

In these specific examples, "tBu" indicates a tert-butyl group.

The content of the group capable of decomposing under the action of an acid is expressed by B/(B+S) using the number (B) of acid-decomposable groups in the resin and the number (S) of alkali-soluble groups not protected by a group which desorbs by the effect of an acid. The content is preferably from 0.01 to 0.7, more preferably from 0.05 to 0.50, still more preferably from 0.05 to 0.40.

### [2] Compound capable of generating acid upon irradiation with actinic rays or radiation

In the resist composition of the present invention, a known compound may be used as the compound capable of generating an acid upon irradiation with actinic rays or radiation (acid generator), but a compound capable of generating a sulfonic acid upon irradiation with actinic rays or radiation (sulfonic acid generator) and/or a compound capable of generating a carboxylic acid upon irradiation with actinic rays or radiation (carboxylic acid generator) are preferably contained.

### <Compound (B) capable of generating sulfonic acid upon irradiation with actinic rays or radiation>

The compound capable of generating a sulfonic acid upon irradiation with actinic rays or radiation (sometimes referred to as a "compound (B)" or a "sulfonic acid generator"), which is contained in the resist composition of the present invention, is a compound capable of generating a sulfonic acid upon irradiation with actinic rays or radiation such as KrF excimer laser, electron beam and EUV, and examples thereof include a diazonium salt, a phosphonium salt, a sulfonium salt, an iodonium salt, an imidosulfonate, an oxime sulfonate, a diazodisulfone, a disulfone and an o-nitrobenzylsulfonate.

Also, a compound where such a group or compound capable of generating an acid upon irradiation with actinic rays or radiation is introduced into the main or side chain of a polymer may be used, and examples thereof include the compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029.

Furthermore, compounds capable of generating an acid by the effect of light described, for example, in U.S. Patent 3,779,778 and European Patent 126,712 may also be used.

In the present invention, from the standpoint of enhancing the image performance such as resolving power and pattern profile, a sulfonium salt, an iodonium salt, an imidosulfonate, an oxime sulfonate, a diazodisulfone and a disulfone are preferred as the sulfonic acid generator.

Particularly preferred examples of these compounds set forth below.

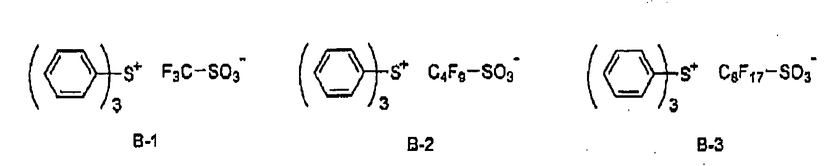

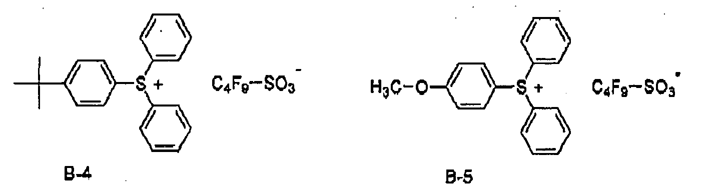

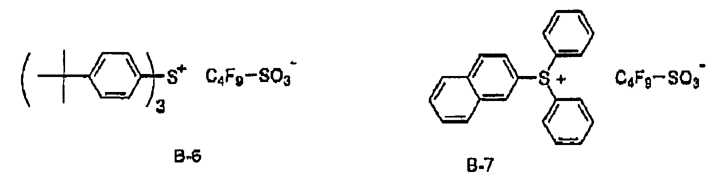

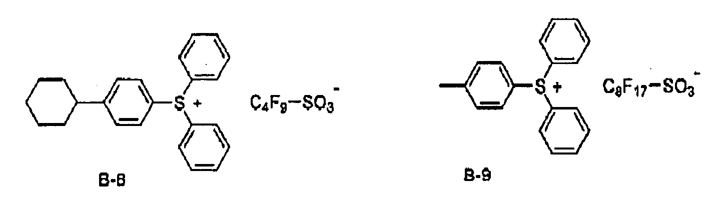

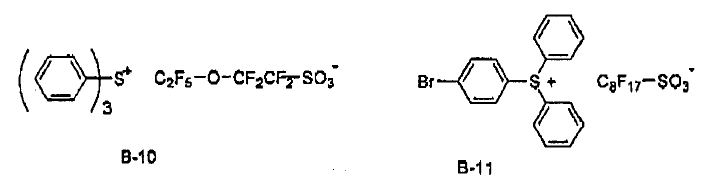

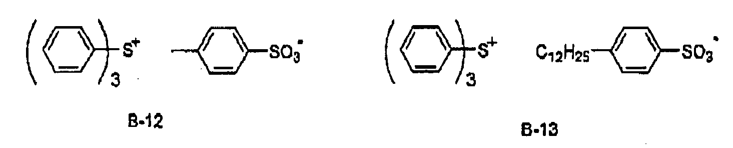

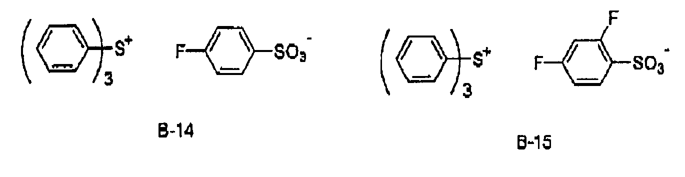

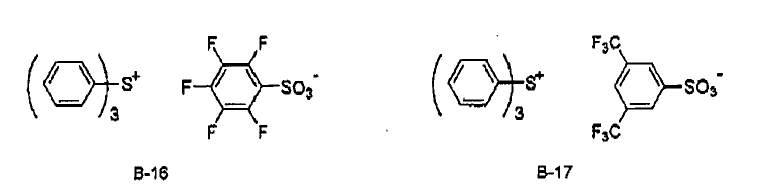

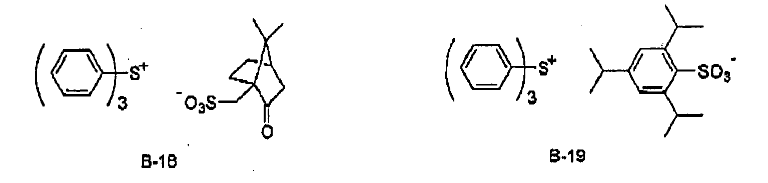

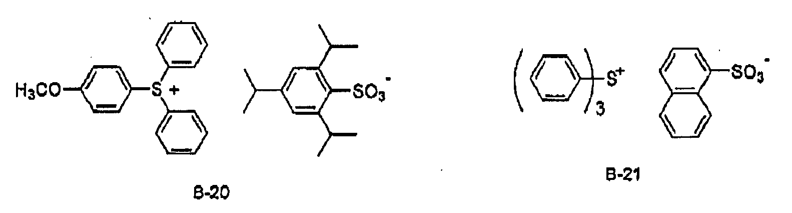

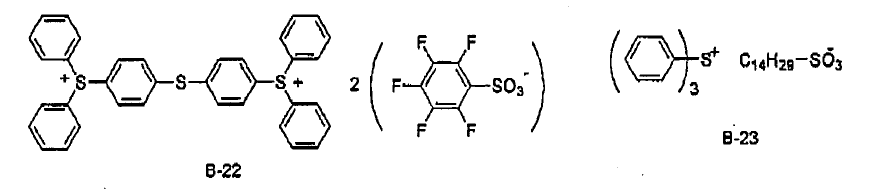

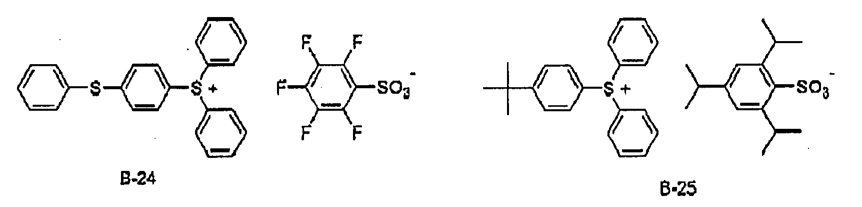

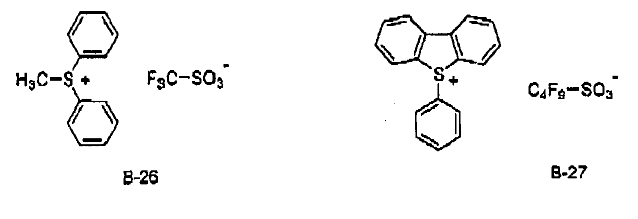

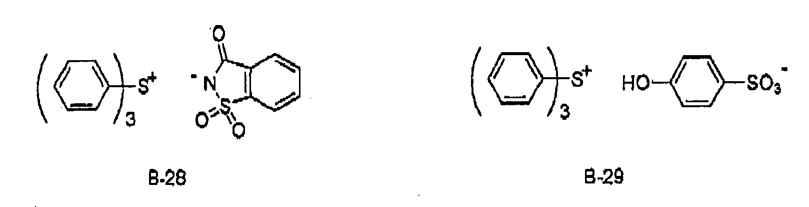

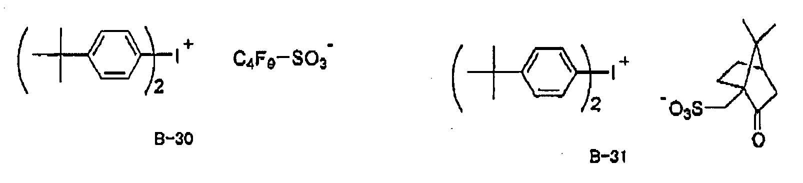

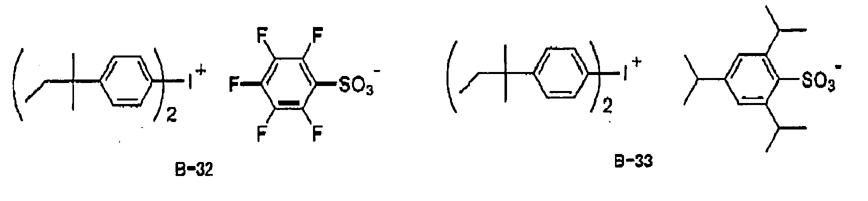

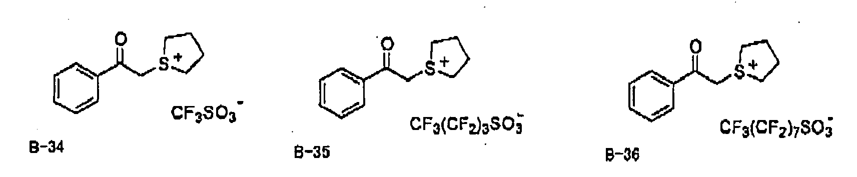

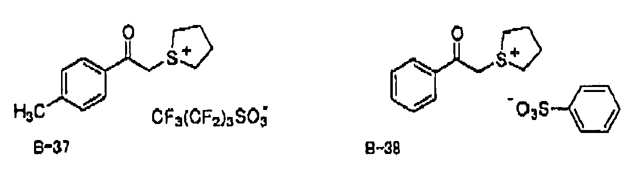

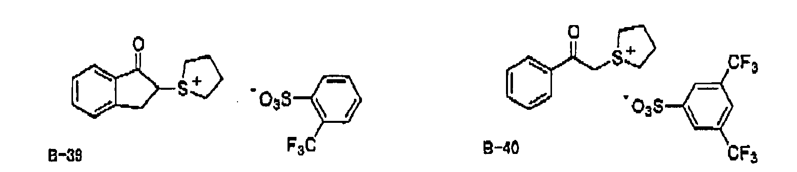

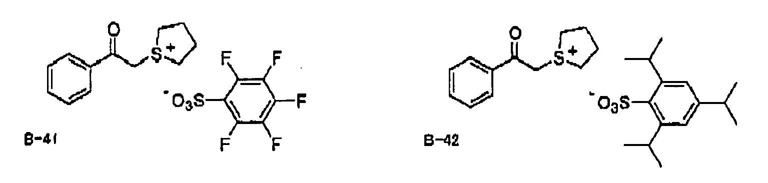

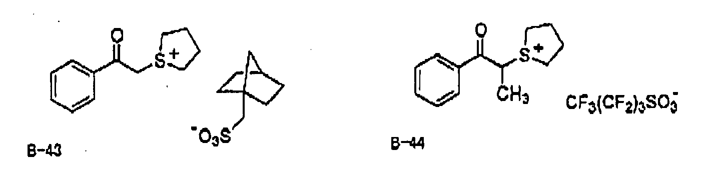

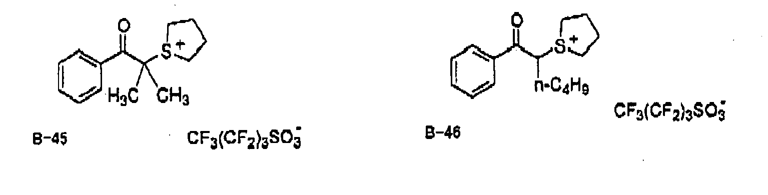

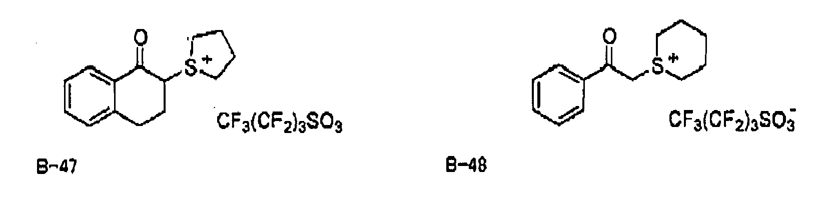

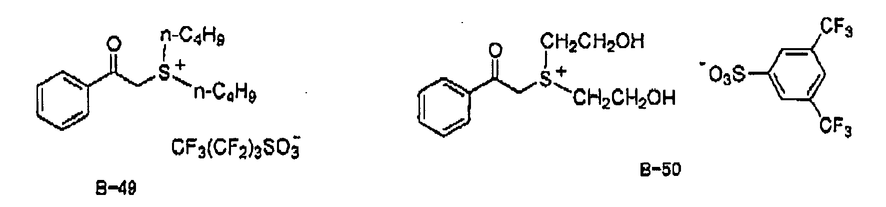

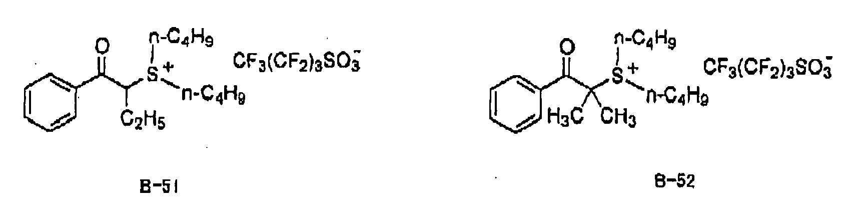

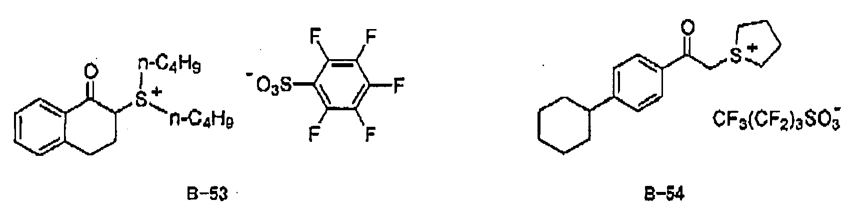

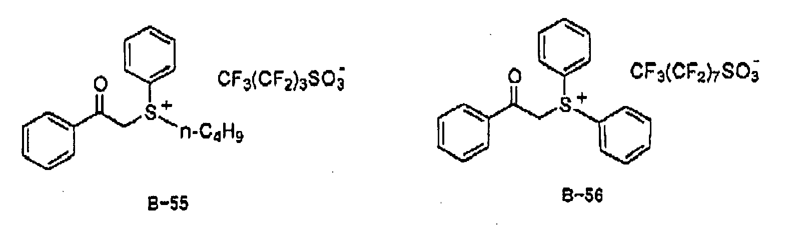

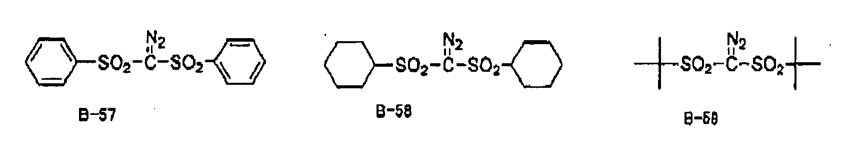

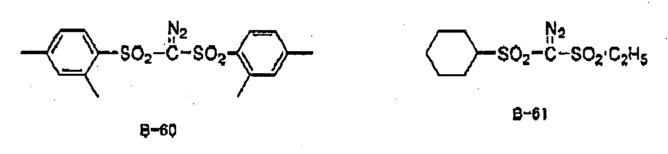

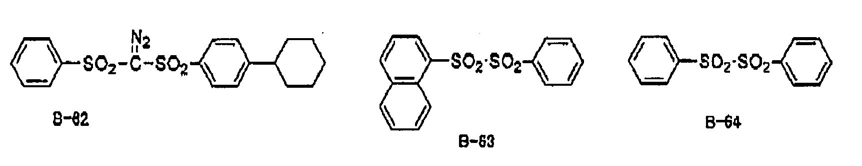

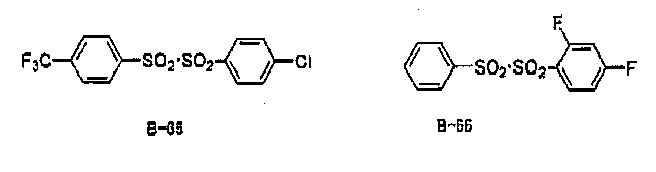

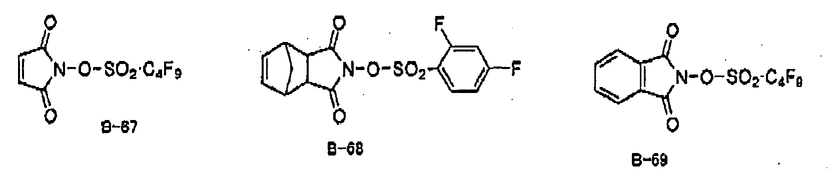

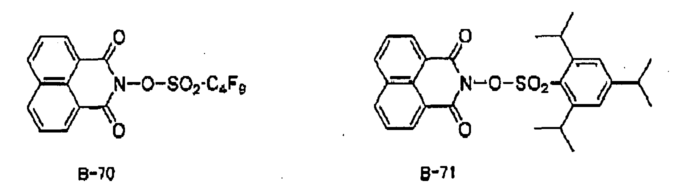

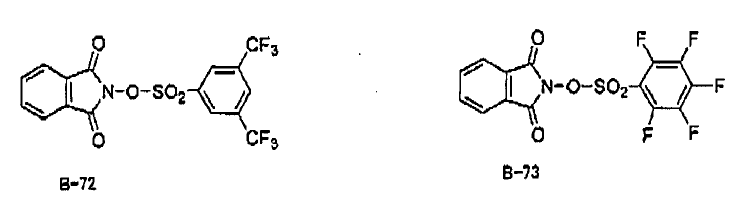

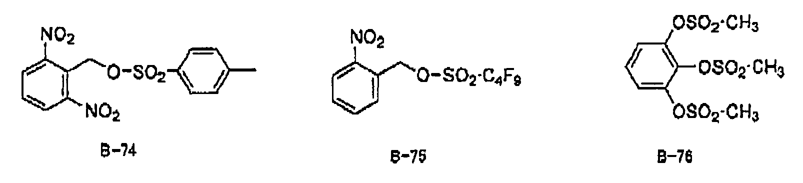

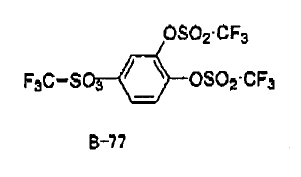

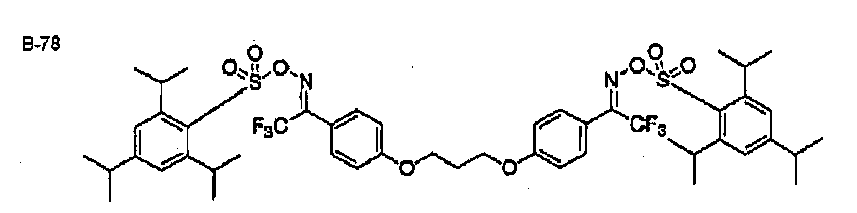

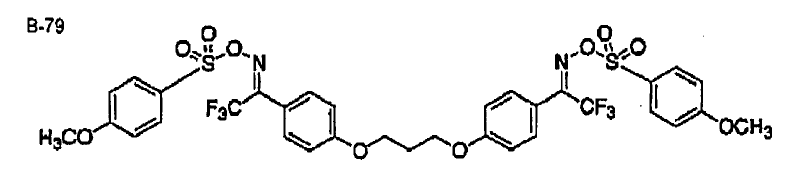

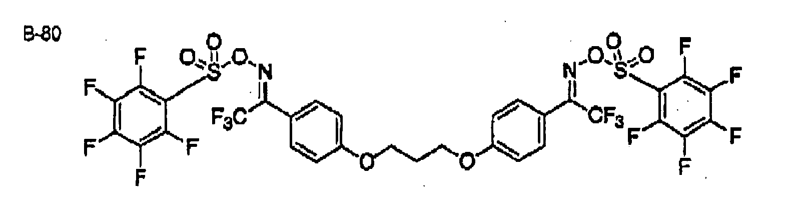

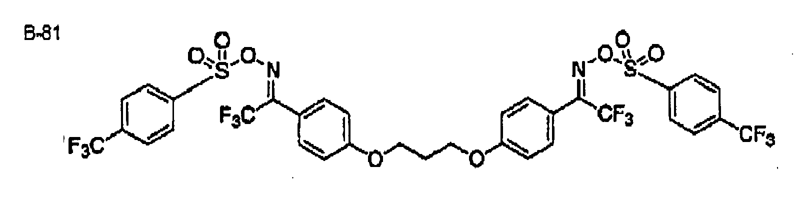

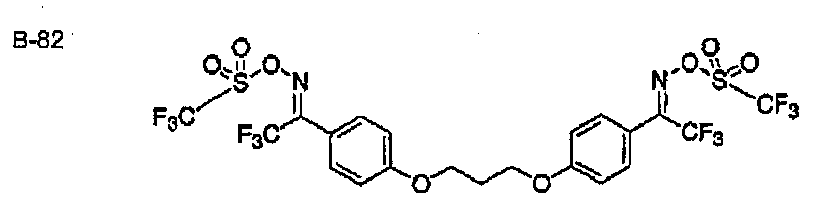

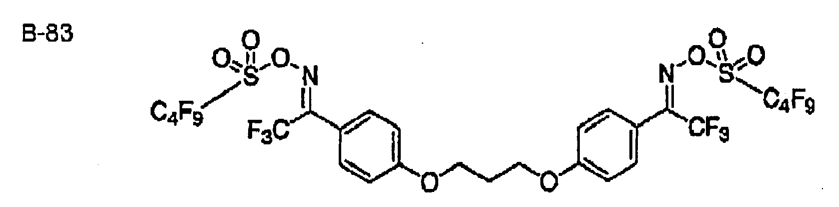

The content of the compound (B) is from 5 to 20 mass%, preferably from 6 to 18 mass%, more preferably from 7 to 16 mass%, based on the entire solid content of the resist composition. The content is 5 mass% or more in view of sensitivity or line edge roughness and 20 mass% or less in view of resolving power, pattern profile and film quality. One species of the compound (B) may be used, or a mixture of two or more species thereof may be used. For example, a compound capable of generating an arylsulfonic acid upon irradiation with actinic rays or radiation and a compound capable of generating an alkylsulfonic acid upon irradiation with actinic rays or radiation may be used in combination as the compound (B).

The compound (B) can be synthesized by a known method such as synthesis method described in JP-A-2002-27806.

### <Compound (C) capable of generating a carboxylic acid upon irradiation with actinic rays or radiation>

In the positive resist composition of the present invention, a compound capable of generating a carboxylic acid upon irradiation with actinic rays or radiation (sometimes referred to as a "compound (C)" or a "carboxylic acid generator") may be used.

The carboxylic acid generator is preferably a compound represented by the following formula (C):

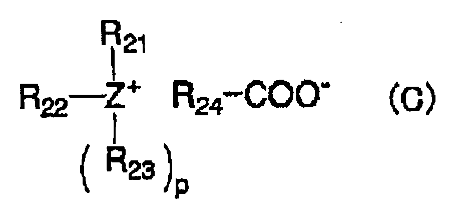

In formula (C), R₂₁ to R₂₃ each independently represents an alkyl group, a cycloalkyl group, an alkenyl group or an aryl group, R₂₄ represents a hydrogen atom, an alkyl group, a cycloalkyl group, an alkenyl group or an aryl group, and Z represents a sulfur atom or an iodine atom. When Z is a sulfur atom, p is 1, and when Z is an iodine atom, p is 0.

In formula (C), R₂₁ to R₂₃ each independently represents an alkyl group, a cycloalkyl group, an alkenyl group or an aryl group, and these groups each may have a substituent.

Examples of the substituent which the alkyl group, cycloalkyl group and alkenyl group may have include a halogen atom (e.g., chlorine, bromine, fluorine), an aryl group (e.g., phenyl, naphthyl), a hydroxy group and an alkoxy group (e.g., methoxy, ethoxy, butoxy).

Examples of the substituent which the aryl group may have include a halogen atom (e.g., chlorine, bromine, fluorine), a nitro group, a cyano group, an alkyl group (e.g., methyl, ethyl, tert-butyl, tert-amyl, octyl), a hydroxy group and an alkoxy group (e.g., methoxy, ethoxy, butoxy).

R₂₁ to R₂₃ each is independently preferably an alkyl group having a carbon number of 1 to 12, a cycloalkyl group having a carbon number of 3 to 12, an alkenyl group having a carbon number of 2 to 12 or an aryl group having a carbon number of 6 to 24, more preferably an alkyl group having a carbon number of 1 to 6, a cycloalkyl group having a carbon number of 3 to 6 or an aryl group having a carbon number of 6 to 18, still more preferably an aryl group having a carbon number of 6 to 15, and these groups each may have a substituent.

R₂₄ represents a hydrogen atom, an alkyl group, a cycloalkyl group, an alkenyl group or an aryl group.

Examples of the substituent which the alkyl group, cycloalkyl group and alkenyl group may have are the same as those of the substituent described above when R₂₁ is an alkyl group, Examples of the substituent for the aryl group are the same as those of the substituent described above when R₂₁ is an aryl group.

R₂₄ is preferably a hydrogen atom, an alkyl group having a carbon number of I to 30, a cycloalkyl group having a carbon number of 3 to 30, an alkenyl group having a carbon number of 2 to 30 or an aryl group having a carbon number of 6 to 24, more preferably an alkyl group having a carbon number of 1 to 18, a cycloalkyl group having a carbon number of 3 to 18 or an aryl group having a carbon number of 6 to 18, still more preferably an alkyl group having a carbon number of 1 to 12, a cycloalkyl group having a carbon number of 3 to 12 or an aryl group having a carbon number of 6 to 15. These groups each may have a substituent.

Z represents a sulfur atom or an iodine atom, p is 1 when Z is a sulfur atom, and 0 when Z is an iodine atom.

Incidentally, two or more cation moieties of formula (C) may combine through a single bond or a linking group (e.g., -S-, -O-) to form a cation structure having a plurality of cation moieties of formula (C).

Specific preferred examples of the compound (C) capable of generating a carboxylic acid upon irradiation with actinic rays or radiation are set forth below, but the present invention is of course not limited thereto.

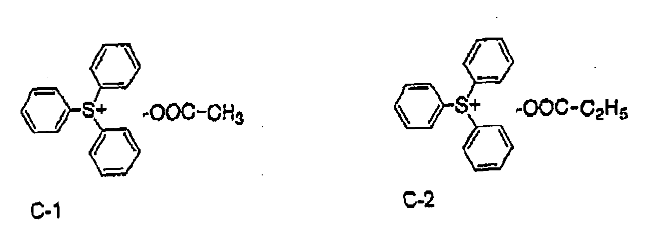

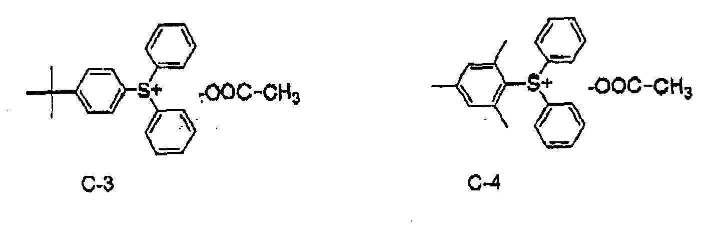

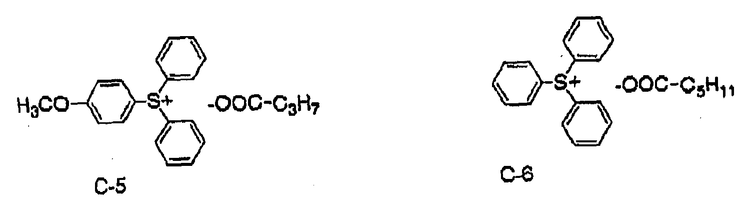

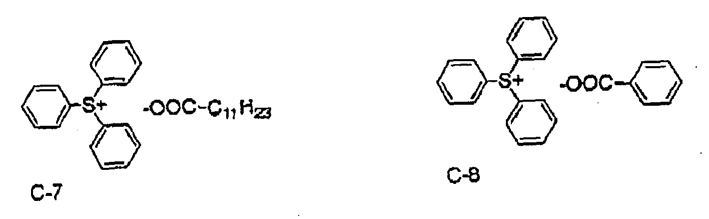

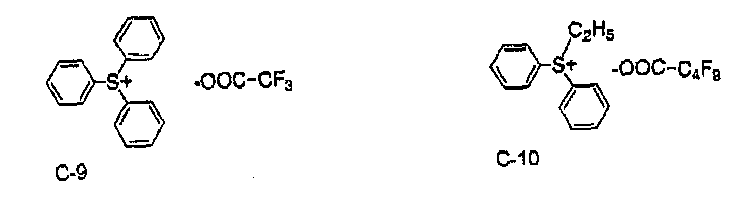

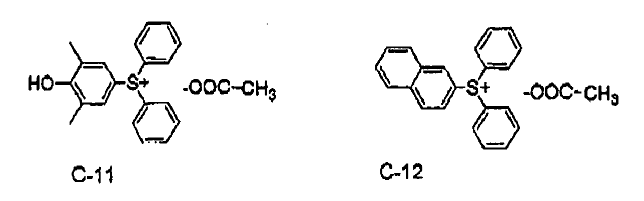

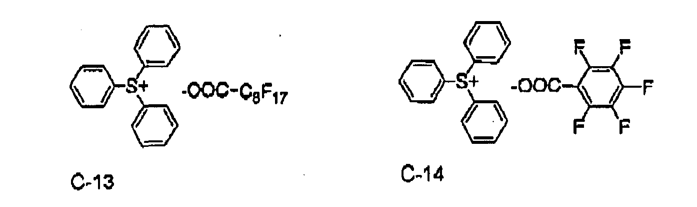

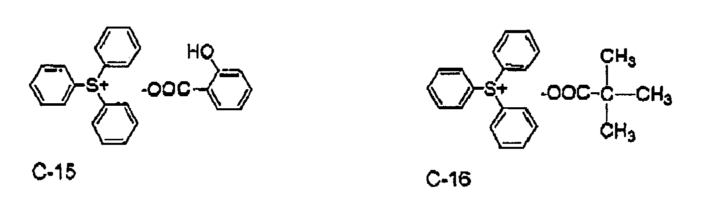

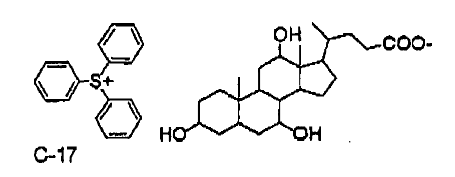

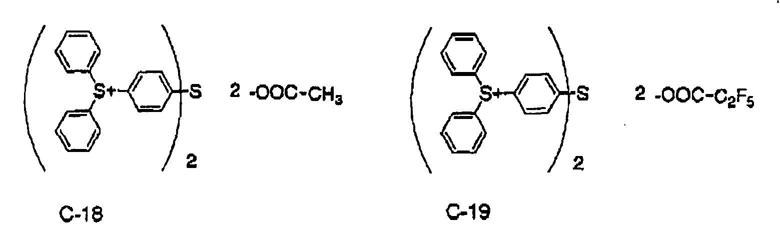

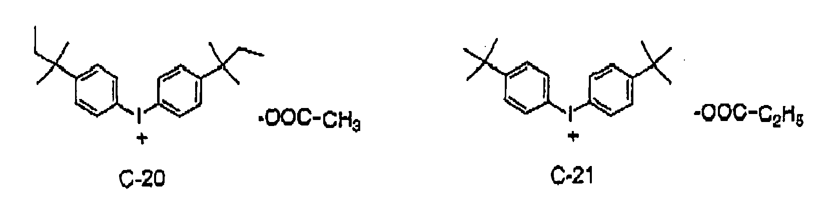

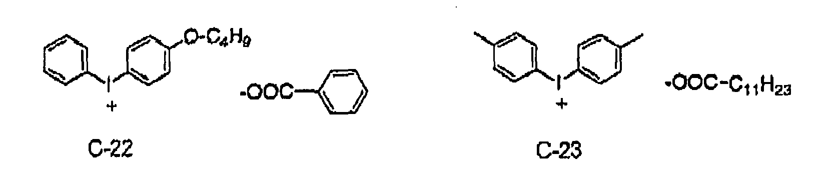

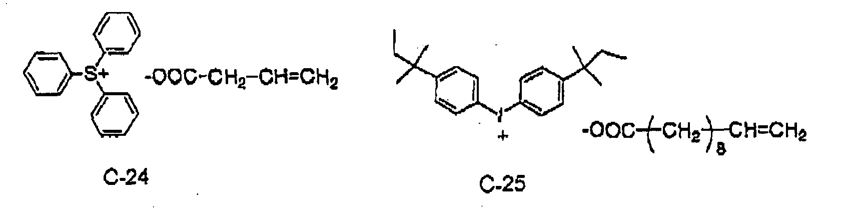

The content of the compound (C) in the positive resist composition of the present invention is preferably from 0.01 to 10 mass%, more preferably from 0.03 to 5 mass%, still more preferably from 0.05 to 3 mass%, based on the entire solid content of the composition. One species of the compound capable of generating a carboxylic acid upon irradiation with actinic rays or radiation may be used, or a mixture of two or more species thereof may be used. The compound (C) can be synthesized by a known method such as synthesis method described in JP-A-2002-27806.

In the present invention, a sulfonic acid generator (compound (B)) is preferred, and a combination use of a sulfonic acid generator (compound (B)) and a carboxylic acid generator (compound (C) is more preferred.

The compound (C)/compound (B) (ratio by mass) is usually from 99.9/0.1 to 50/50, preferably from 99/1 to 60/40, more preferably from 98/2 to 70/30.

### [3] Organic basic compound

In the present invention, an organic basic compound is preferably used from the standpoint of, for example, enhancing the performance such as resolving power or the storage stability. The organic basic compound is more preferably a compound containing a nitrogen atom (nitrogen-containing basic compound).

The organic basic compound preferred in the present invention is a compound having basicity stronger than that of phenol.

Preferred chemical environments thereof include structures of the following formulae (A) to (E). The structures of formulae (B) to (E) each may be a part of a ring structure.

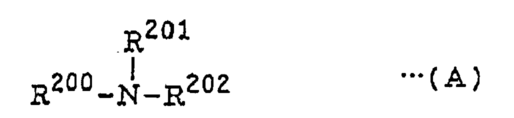

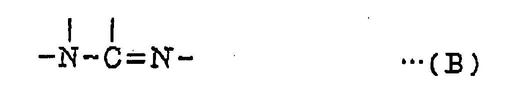

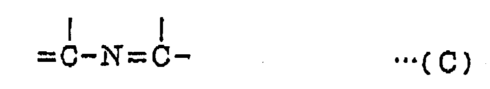

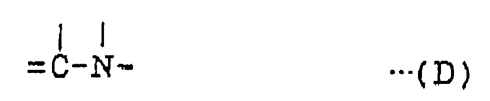

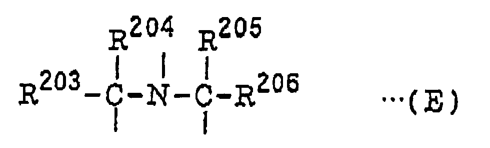

In formula (A), R²⁰⁰, R²⁰¹ and R²⁰², which may be the same or different, each represents a hydrogen atom, an alkyl group (preferably having a carbon number of 1 to 20), a cycloalkyl group (preferably having a carbon number of 3 to 20) or an aryl group (preferably having a carbon number of 6 to 20), and R²⁰¹ and R²⁰² may combine with each other to form a ring.

The alkyl group, cycloalkyl group and aryl group as R²⁰⁰, R²⁰¹ and R²⁰² each may have a substituent. The alkyl group or cycloalkyl group having a substituent is preferably an aminoalkyl group or aminocycloalkyl group having a carbon number of I to 20 or a hydroxyalkyl group having a carbon number of 1 to 20.

In formula (E), R²⁰³, R²⁰⁴, R²⁰⁵ and R²⁰⁶, which may be the same or different, each represents an alkyl group having a carbon number of 1 to 6 or a cycloalkyl group.

The compound is more preferably a nitrogen-containing basic compound having two or more nitrogen atoms differing in the chemical environment within one molecule, still more preferably a compound containing both a substituted or unsubstituted amino group and a nitrogen-containing ring structure, or a compound having an alkylamino group.

Specific preferred examples thereof include guanidine, aminopyridine, aminoalkylpyridine, aminopyrrolidine, indazole, imidazole, pyrazole, pyrazine, pyrimidine, purine, imidazoline, pyrazoline, piperazine, aminomorpholine and aminoalkylmorpholine. Preferred examples of the substituent which these compounds may have include an amino group, an alkylamino group, an aminoaryl group, an arylamino group, an alkyl group (as the substituted alkyl group, an aminoalkyl group in particular), an alkoxy group, an acyl group, an acyloxy group, an aryl group, an aryloxy group, a nitro group, a hydroxyl group and a cyano group.

More preferred examples of the compound include, but are not limited to, guanidine, 1,1-dimethylguanidine, 1,1,3,3-tetramethylguanidine, imidazole, 2-methylimidazole, 4-methylimidazole, N-methylimidazole, 2-phenylimidazole, 4,5-diphenylimidazole, 2,4,5-triphenylimidazole, 2-aminopyridine, 3-aminopyridine, 4-aminopyridine, 2-dimethylaminopyridine, 4-dimethylaminopyridine, 2-diethylaminopyridine, 2-(aminomethyl)pyridine, 2-amino-3-methylpyridine, 2-amino-4-methylpyridine, 2-amino-5-methylpyridine, 2-amino-6-methylpyridine, 3-aininoethylpyridine, 4-aminoethylpyridine, 3-aminopyrrolidine, piperazine, N-(2-aminoethyl)pipexazine, N-(2-aminoethyl)piperidine, 4-amino-2,2,6,6-tetramethylpiperidine, 4-piperidinopiperidine, 2-iminopiperidine, 1-(2-aminoethyl)pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4,6-dihydroxypyrimidine, 2-pyrazoline, 3-pyrazoline, N-aminomorpholine and N-(2-aminoethyl)morpholine,

One of these nitrogen-containing basic compounds may be used alone, or two or more species thereof may be used in combination.

A tetraalkylammonium salt-type nitrogen-containing basic compound may also be used. Among such compounds, a tetraalkylammonium hydroxide having a carbon number of 1 to 8 (e.g., tetramethylammonium hydroxide, tetraethylammonium hydroxide, tetra-(n-butyl)ammonium hydroxide) is preferred. One of these nitrogen-containing basic compounds may be used alone, or two or more species thereof may be used in combination.

As for the ratio between the acid generator and the organic basic compound used in the composition, the (total amount of acid generator)/(organic basic compound) (ratio by mol) is preferably from 2.5 to 300. When this molar ratio is 2.5 or more, high sensitivity is obtained, and when the molar ratio is 300 or less, the resist pattern can be prevented from thickening in aging after exposure until heat treatment and the resolving power can be enhanced. The (total amount of acid generator)/(organic basic compound) (ratio by mol) is more preferably from 5.0 to 200, still more preferably from 7.0 to 150.

### [4] Surfactants

In the present invention, surfactants can be used and use thereof is preferred in view of film-forming property and adhesion of pattern.

Specific examples of the surfactant include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene•polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate); a fluorine-containing surfactant and a silicon-containing surfactant, such as EFtop EF301, EF303 and EF352 (produced by Shin-Akita Chemical Co., Ltd.), Megafac F171 and F173 (produced by Dainippon Ink & Chemicals, Inc.), Florad FC430 and FC431 (produced by Sumitomo 3M Inc.), Asahiguard AG710, Surflon S-382, SC101, SC102, SC103, SC104, SC105 and SC106 (produced by Asahi Glass Co., Ltd.), and Troysol S-366 (produced by Troy Chemical Industries, Inc.); an organosiloxane polymer, KP-341 (produced by Shin-Etsu Chemical Co., Ltd.); and acrylic acid-based or methacrylic acid-based (co)polymers, Polyflow No. 75 and No. 95 (produced by Kyoeisha Yushi Kagaku Kogyo Co., Ltd.). The blending amount of such a surfactant is usually 2 parts by mass or less, preferably 1 part by mass or less, per 100 parts by mass of the solid content in the composition of the present invention.

One of these surfactants may be used alone or several species thereof may be added in combination.

As for the surfactant, the composition preferably contains any one species of fluorine- and/or silicon-containing surfactants (a fluorine-containing surfactant, a silicon-containing surfactant or a surfactant containing both a fluorine atom and a silicon atom), or two or more species thereof.

Examples of these surfactants include the surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing or silicon-containing surfactant such as EFtop EF301 and EF303 (produced by Shin-Akita Chemical Co., Ltd.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical Industries, Inc.). In addition, a polysiloxane polymer, KP-341 (produced by Shin-Etsu Chemical Co., Ltd.), may also be used as the silicon-containing surfactant.

Other than these known surfactants, a surfactant using a polymer having a fluoroaliphatic group which is derived from a fluoroaliphatic compound produced by a telomerization process (also called a telomer process) or an oligomerization process (also called an oligomer process), may be used. The fluoroaliphatic compound can be synthesized by the method described in JP-A-2002-90991.

The polymer having a fluoroaliphatic group is preferably a copolymer of a fluoroaliphatic group-containing monomer with a (poly(oxyalkylene)) acrylate and/or a (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) and block-linked poly(oxyethylene and oxypropylene). Furthermore, the copolymer of a fluoroaliphatic group-containing monomer with a (poly(oxyalkylene)) acrylate (or methacrylate) may be not only a binary copolymer but also a ternary or higher copolymer obtained by simultaneously copolymerizing two or more different fluoroaliphatic group-containing monomers or two or more different (poly(oxyalkylene)) acrylates (or methacrylates).

Examples thereof include commercially available surfactants such as Megafac F178, F-470, F-473, F-475, F-476 and F-472 (produced by Dainippon Ink & Chemicals, Inc.), and further include a copolymer of a C₆F₁₃ group-containing acrylate (or methacrylate) with a (poly(oxyalkylene)) acrylate (or methacrylate), a copolymer of a C₆F₁₃ group-containing acrylate (or methacrylate) with (poly(oxyethylene)) acrylate (or methacrylate) and (poly(oxypropylene)) acrylate (or methacrylate), a copolymer of a C₈F₁₇ group-containing acrylate (or methacrylate) with a (poly(oxyalkylene)) acrylate (or methacrylate), and a copolymer of a C₈F₁₇ group-containing acrylate (or methacrylate) with (poly(oxyethylene)) acrylate (or methacrylate) and (poly(oxypropylene)) acrylate (or methacrylate).

The amount of the surfactant used is preferably from 0.0001 to 2 mass%, more preferably from 0.001 to 1 mass%, based on the entire amount of the positive resist composition (excluding the solvent).

### [5] Other components

The positive resist composition of the present invention may further contain, if desired, a dye, a photobase generator and the like.

### 1. Dye

In the present invention, a dye may be used.

The suitable dye includes an oily dye and a basic dye. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industries Co., Ltd.), Crystal Violet (CI42555), Methyl Violet (CI42535), Rhodamine B (CI45170B), Malachite Green (CI42000) and Methylene Blue (CI52015).

### 2, Photobase generator

Examples of the photobase generator which can be added to the composition of the present invention include the compounds described in JP-A-4-151156, JP-A-4-162040, JP-A-5-197148, JP-A-5-5995, JP-A-6-194834, JP-A-8-146608, JP-A-10-83079 and European Patent 622,682. Specific examples of the photobase generator which can be suitably used include 2-nitrobenzyl carbamate, 2,5-dinitrobenzylcyclohexyl carbamate, N-eyelohexyl-4-methylphenylsulfonamide and 1,1-dimethyl-2-phenylethyl-N-isopropyl carbamate. Such a photobase generator is added for the purpose of improving the resist profile or the like.

### 3. Solvents

The resist composition of the present invention is dissolved in a solvent capable of dissolving respective components above and then coated on a support. Usually, the concentration is, in terms of the solid content concentration of all resist components, preferably from 2 to 30 mass%, more preferably from 3 to 25 mass%.

The solvent used here is preferably a mixed solvent containing (C1) a propylene glycol monoalkyl ether carboxylate and (C2) at least one member selected from a propylene glycol monoalkyl ether, an alkyl lactate, an acetic acid ester, an alkyl alkoxypropionate, a chain ketone and a cyclic ketone.

As for (C1), the propylene glycol monoalkyl ether carboxylate is preferably propylene glycol monomethyl ether acetate, propylene glycol monomethyl ether propionate or propylene glycol monoethyl ether acetate. As for (C2), the propylene glycol monoalkyl ether is preferably propylene glycol monomethyl ether or propylene glycol monoethyl ether; the alkyl lactate is preferably ethyl lactate or butyl lactate; the acetic acid ester is preferably butyl acetate; the alkyl alkoxypropionate is preferably methoxymethyl propionate or ethoxyethyl propionate; the chain ketone is preferably methyl amyl ketone; and the cyclic ketone is preferably cyclohexanone, γ-butyrolactone or propylene carbonate.

Above all, a combination of (C1) propylene glycol monomethyl ether acetate and (C2) propylene glycol monomethyl ether, ethyl lactate, butyl acetate, ethoxyethyl propionate or methyl amyl ketone is preferred. This combination brings about excellent performance particularly in view of development defect.

The solvent ratio (C1)/(C2) (ratio by mass) is preferably from 15/85 to 90/10, more preferably from 30/70 to 85/15, still more preferably from 50/50 to 80/20.

The positive resist composition of the present invention is coated on a substrate to form a thin film. The thickness of this coating film is preferably from 0.05 to 4.0 µm.

In the present invention, a commercially available inorganic or organic antireflection film may be used, if desired. Furthermore, the antireflection film may be used by coating it as an underlayer of the resist.

The antireflection film used as the underlayer of the resist may be either an inorganic film type such as titanium, titanium dioxide, titanium nitride, chromium oxide, carbon and amorphous silicon, or an organic film type comprising a light absorbent and a polymer material. The former requires equipment for the film formation, such as vacuum deposition apparatus, CVD apparatus and sputtering apparatus. Examples of the organic antireflection film include a film comprising a diphenylamine derivative/formaldehyde-modified melamine resin condensate, an alkali-soluble resin and a light absorbent described in JP-B-7-69611 (the term "JP-B" as used herein means an "examined Japanese patent publication"), a reaction product of a maleic anhydride copolymer and a diamine-type light absorbent described in U.S. Patent 5,294,680, a film containing a resin binder and a methylolmelamine-based heat crosslinking agent described in JP-A-6-118631, an acrylic resin-type antireflection film containing a carboxylic acid group, an epoxy group and a light absorbing group within the same molecule described in JP-A-6-118656, a film comprising a methylolmelamine and a benzophenone-based light absorbent described in JP-A-8-87115, and a film obtained by adding a low molecular light absorbent to a polyvinyl alcohol resin described in JP-A-8-179509.

Also, the organic antireflection film may be a commercially available organic antireflection film such as DUV-30 Series and DUV-40 Series produced by Brewer Science, Inc.; and AR-2, AR-3 and AR-5 produced by Shipley Co., Ltd.

In the production or the like of a precision integrated circuit device, the step of forming a pattern on a resist film is performed by coating the positive resist composition of the present invention on a substrate (for example, a silicon/silicon dioxide-coated substrate, a glass substrate, an ITO substrate or a quartz/chromium oxide-coated substrate) to form a resist film, irradiating thereon actinic rays or radiation such as KrF excimer laser light, electron beam or EUV light, and then subjecting the resist film to heating, development, rinsing and drying, whereby a good resist pattern can be formed.

The alkali developer which can be used in the development is an aqueous solution of alkalis (usually, from 0.1 to 20 mass%) such as inorganic alkalis (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcohol amines (e.g., dimethylethanolamine, triethanolamine), quaternary ammonium salts (e.g., tetramethylammonium hydroxide, tetraethylammonium hydroxide, choline) and cyclic amines (e.g., pyrrole, piperidine). This aqueous solution of alkalis may be used after adding thereto alcohols such as isopropyl alcohol or a surfactant such as nonionic surfactant, in an appropriate amount.

Among these developers, a quaternary ammonium salt is preferred, and tetramethylammonium hydroxide and choline are more preferred.

The pH of the alkali developer is usually from 10 to 15.

### [Examples]

The present invention is described in greater detail below by referring to Examples, but the present invention should not be construed as being limited thereto.

### [Synthesis Example 1: synthesis of Resin A-40 as the resin (A)]:

Acetoxystyrene and 1-phenylethyl methacrylate were charged at a ratio of 90/10 (by mol) and dissolved in cyclohexanone to prepare 100 ml of a solution having a solid content concentration of 20 mass%. Subsequently, 2 mol% of a polymerization initiator, V-601, produced by Wako Pure Chemical Industries, Ltd. was added thereto, and the resulting solution was added dropwise to 10 ml of cyclohexanone heated at 80°C, over 4 hours in a nitrogen atmosphere. After the completion of dropwise addition, the reaction solution was heated for 4 hours, and 1 mol% of V-601 was again added, followed by stirring for 4 hours. After the completion of reaction, the reaction solution was cooled to room temperature and then crystallized in 3 L of hexane, and the precipitated white powder was collected by filtration.

The compositional ratio of the polymer determined from C¹³NMR was 89/11 (by mol), Also, the weight average molecular weight determined by GPC was 9,500 in terms of standard polystyrene.

This polymer was dissolved in 100 ml of tetrahydrofuran, 5 ml of tetramethylammonium hydroxide (TMAH) was then added thereto and after stirring 1 hour, distilled water was added to precipitate the polymer. The precipitate was washed with distilled water and dried under reduced pressure. Furthermore, the polymer was dissolved in 100 ml of ethyl acetate and after adding hexane, the polymer precipitated was dried under reduced pressure to a powder form. The weight average molecular weight determined by the GPC measurement of this powder was 10,000 in terms of the standard polystyrene.

The obtained resin was dissolved in PGMEA, pyridinium para-toluenesulfonic acid and ethyl vinyl ether were added thereto in an amount of 1 mol% and 25 mol%, respectively, based on the polymer, and the reaction was allowed to proceed at room temperature for 4 hours. After terminating the reaction by adding 10 mol% of triethylamine, the reaction product was washed with pure water, and PGMEA and water were removed by azeotropic distillation, whereby a PGMEA solution of Resin (A-40) was synthesized.

The compositional ratio of the polymer determined from C¹³NMR was 69/11/20 (by mol). Also, the weight average molecular weight determined by GPC was 12,000 in terms of standard polystyrene.

Resins shown in Table 1, of which structures are illustrated above, were synthesized in the same manner as in Synthesis Example 1. In Table 1, the ratio of repeating units in each resin is a ratio of repeating units starting from the left in each structure illustrated above.

**Table 1**

| Resin | Repeating Unit (mol%) | Weight Average Molecular Weight |
|---|---|---|
| A-1 | 65/35 | 9800 |
| A-2 | 60/30/10 | 11500 |
| A-5 | 66/34 | 9900 |
| A-7 | 65/35 | 9900 |
| A-14 | 66/12/22 | 9800 |
| A-20 | 63/37 | 7750 |
| A-22 | 63/37 | 7450 |
| A-26 | 67/33 | 8800 |
| A-40 | 69/11/20 | 12000 |
| R-7 | 15/65/20 | 9500 |
| R-18 | 71/29 | 15000 |

The resins containing at least one repeating unit selected from a repeating unit represented by formula (A1) and a repeating unit represented by formula (A2), of which solubility in an alkali developer increases under the action of an acid, and the acid generators, used in Examples of the present invention, all were synthesized by a known synthesis method such as synthesis method described in JP-A-2002-27806.

### Examples (Examples, Comparative Examples)

### (1) Preparation and Coating of Positive Resist

The components shown in Table 2 below were dissolved, and the obtained solution was microfiltered through a membrane filter having a pore size of 0.1 µm to prepare a resist solution.

An antireflection film, DUV-44, produced by Nissan Chemicals Industries, Ltd. was coated on a 8-inch silicon wafer by using a spin coater, ACT8, manufactured by Tokyo Electron Ltd. and then baked at 200°C for 60 seconds to obtain a film having an average thickness of 60 nm. Subsequently, the resist solution prepared above as coated thereon and baked at 120°C for 60 seconds to obtain a film having an average thickness of 280 nm.

**Table 2**

| | Resin (0.966 g) | Acid Generator (0.03 g) | Organic Basic Compound (0.003 g) | Surfactant (0.001 g) | Solvent (14 g) | | |
|---|---|---|---|---|---|---|---|
| | | | | | A | B | Ratio |
| Example 1 | A-1 | B-1 | D-1 | W-1 | C1-1 | C2-1 | 70/30 |
| Example 2 | A-1 | B-1 | D-1 | W-1 | C1-1 | C2-2 | 70/30 |
| Example 3 | A-1 | B-1 | D-1 | W-1 | C1-1 | C2-3 | 70/30 |
| Example 4 | A-1 | B-1 | D-1 | W-1 | C1-1 | C2-4 | 70/30 |
| Example 5 | A-1 | B-1 | D-1 | W-1 | C1-1 | C2-5 | 70/30 |
| Example 6 | A-2 | B-1 | D-1 | W-1 | C1-2 | C2-1 | 80/20 |
| Example 7 | A-2 | B-31 | D-1 | W-2 | C1-1 | C2-2 | 80/20 |
| Example 8 | A-5 | B-1 | D-1 | W-1 | C1-1 | C2-1 | 70/30 |
| Example 9 | A-5 | B-1 | D-1 | W-2 | C1-2 | C2-4 | 70/30 |
| Example 10 | A-5 | B-58 | D-1 | W-1 | C1-1 | C2-1/C2-5 | 70/20/10 |
| Example 11 | A-5 | B-1 | D-1 | W-1 | C1-3 | C2-6 | 70/30 |
| Example 12 | A-7 | B-1 | D-1 | W-1 | C1-1 | C2-1 | 60/40 |
| Example 13 | A-7 | B-31 | D-1 | W-2 | C1-1 | C2-7 | 30/70 |
| Example 14 | A-14 | B-1 | D-1 | W-1 | C1-1 | C2-1 | 80/20 |
| Example 15 | A-14 | B-25 | D-1 | W-2 | C1-1 | C2-2/C2-5 | 70/20/10 |
| Example 16 | A-14 | B-1 | D-1 | W-1 | C1-2 | C2-4 | 50/50 |
| Example 17 | A-20 | B-1 | D-1 | W-1 | C1-2 | C2-2 | 80/20 |
| Example 18 | A-20 | B-58 | D-1 | W-2 | C1-1 | C2-6 | 70/30 |
| Example 19 | A-22 | B-1 | D-1 | W-1 | C1-1 | C2-2 | 90/10 |
| Example 20 | A-22 | B-1 | D-1 | W-2 | C1-2 | C2-8 | 30/70 |
| Example 21 | A-26 | B-1 | D-1 | W-1 | C1-1 | C2-2 | 70/30 |
| Example 22 | A-26 | B-1 | D-1 | W-1 | C1-2 | C2-1 | 60/40 |
| Example 23 | A-26 | B-25 | D-1 | W-2 | C1-1 | C2-1/ C2-2 | 70/20/10 |
| Example 24 | A-40 | B-1 | D-1 | W-1 | C1-1 | C2-2 | 70/30 |
| Example 25 | A-40 | B-1 | D-1 | W-1 | C1-2 | C2-3 | 70/30 |
| Example 26 | A-40 | B-58 | D-1 | W-2 | C1-1 | C2-1 | 60/40 |
| Example 27 | A-40 | B-1 | D-1 | W-2 | C1-1 | C2-1/C2-5 | 70/20/10 |
| Example 28 | A-40 | B-1 | D-1 | W-2 | C1-1 | C2-9 | 60/40 |
| | | | | | | | |
| Comparative Example 1 | R-7 | B-1 | D-1 | W-1 | Cl-1 | C2-1 | 70/30 |
| Comparative Example 2 | R-7 | B-1 | D-1 | W-1 | C1-1 | C2-5 | 70/30 |
| Comparative Example 3 | R-18 | B-31 | D-1 | W-1 | C1-1 | C2-2 | 70/30 |
| Comparative Example 4 | R-18 | B-1 | D-1 | W-2 | C1-1 | C2-2 | 50/50 |
| Comparative Example 5 | R-18 | B-1 | D-1 | W-1 | C2-2 | C2-9 | 60/40 |

The components used in Examples and Comparative Examples are as follows.

### <Organic Basic Compound>

- D-1:: Tetra-(n-butyl)ammonium hydroxide

### <Surfactant>

- W-1:: Fluorine-containing surfactant, Megafac F-176 (produced by Dainippon Ink & Chemicals, Inc.)
- W-2:: Silicon-containing surfactant, Polysiloxane Polymer KP-341 (produced by Shin-Etsu Chemical Co., Ltd.)

The solvents are shown in Table 3.

**Table 3**

| | Name of Solvent |
|---|---|
| C1-1 | propylene glycol monomethyl ether acetate |
| C1-2 | propylene glycol monomethyl ether propionate |
| C1-3 | propylene glycol monoethyl ether acetate |
| C2-1 | propylene glycol monomethyl ether |
| C2-2 | ethyl lactate |
| C2-3 | methoxymethyl propionate |
| C2-4 | ethoxyethyl propionate |
| C2-5 | methyl amyl ketone |
| C2-6 | cyclohexanone |
| C2-7 | γ-butyrolactone |
| C2-8 | propylene carbonate |
| C2-9 | propylene glycol monoethyl ether |

### (2) Formation of Positive Resist Pattern

The obtained resist film was then subjected to pattern exposure using a KrF excimer laser scanner (PAS5500/850C, manufactured by ASML, wavelength: 248 nm, NA: 0.75, sigma: 0.80). After the irradiation, the resist film was baked at 130°C for 60 seconds, dipped in an aqueous 2.38 mass% tetramethylammonium hydroxide (TMAH) solution for 60 seconds, rinsed with water for 30 seconds and dried. The obtained pattern was evaluated by the following methods.

### (2-1) Sensitivity

The line width of the obtained pattern was observed by a scanning electron microscope (S-9260, manufactured by Hitachi, Ltd.), and the irradiation energy when resolving a 0.15-µm line (line:space =1:1) was defined as the sensitivity.

### (2-2) Evaluation of Resolving Power

To what µm the line:space=1:1 was resolved with the sensitivity obtained in (2-1) was observed by the same scanning electron microscope as above.

### (2-3) Development Defect

A 0.15-µm pattern was exposed at 78 portions in the wafer plane with the sensitivity obtained in (2-1) in the same manner as in (2) with the same exposure amount. The number of development defects in the obtained wafer with a pattern was measured by KLA-2360 manufactured by KLA Tencor Co., Ltd. At this time, the area of inspection was 205 cm² in total, the pixel size was 0.25 µm, the threshold was 30, and visible light was used as the inspection light. The value obtained by dividing the measured numerical value by the area of inspection was defined as the number of development defects (defects/cm²), and this was rated A when the value obtained was less than 0.5, rated B when from 0.5 to less than 1, and rated C when 1.0 or more.

The evaluation results of Examples 1 to 28 and Comparative Examples 1 to 5 are shown in Table 4.

**Table 4**

| | Resin (0.966 g) | Acid Generator (0.03 g) | Basic Compound (0.003 g) | Surfactant (0.001 g) | Solvent (14g) | | | Sensitivity (mJ/cm²) | Resolving Power (µm) | Development Defect | |
|---|---|---|---|---|---|---|---|---|---|---|---|
| | | | | | A | B | Ratio | | | Number of (defects/cm²) | Rating |
| Example 1 | A-1 | B-1 | D-1 | W-1 | C1-1 | C2-1 | 70/30 | 17.0 | 0.125 | 0.2 | A |
| Example 2 | A-1 | B-1 | D-1 | W-1 | C1-1 | C2-2 | 70/30 | 17.0 | 0.125 | 0.2 | A |
| Example 3 | A-1 | B-1 | D-1 | W-1 | C1-1 | C2-3 | 70/30 | 17.0 | 0.125 | 0.3 | A |
| Example 4 | A-1 | B-1 | D-1 | W-1 | C1-1 | C2-4 | 70/30 | 17.0 | 0.125 | 0.4 | A |
| Example 5 | A-1 | B-1 | D-1 | W-1 | C1-1 | C2-5 | 70/30 | 17.0 | 0.125 | 0.4 | A |
| Example 6 | A-2 | B-1 | D-1 | W-1 | C1-2 | C2-1 | 80120 | 15.5 | 0.130 | 0.7 | B |
| Example 7 | A-2 | B-31 | D-1 | W-2 | C1-1 | C2-2 | 80/20 | 15.0 | 0.135 | 0.4 | A |
| Example 8 | A-5 | B-1 | D-1 | W-1 | C1-1 | C2-1 | 70/30 | 15.5 | 0.125 | 0.2 | A |
| Example 9 | A-5 | B-1 | D-1 | W-2 | C1-2 | C2-4 | 70/30 | 16.0 | 0.125 | 0.5 | B |
| Example 10 | A-5 | B-58 | D-1 | W-1 | C1-1 | C2-1/C2-5 | 70/20/10 | 16.5 | 0.125 | 0.2 | A |
| Example 11 | A-5 | B-1 | D-1 | W-1 | C1-3 | C2-6 | 70/30 | 15.5 | 0.125 | 0.7 | B |
| Example 12 | A-7 | B-1 | D-1 | W-1 | C1-1 | C2-1 | 60/40 | 15.5 | 0.125 | 0.4 | A |
| Example 13 | A-7 | B-31 | D-1 | W-2 | C1-1 | C2-7 | 30/70 | 15.0 | 0.125 | 0.8 | B |
| Example 14 | A-14 | B-1 | D-1 | W-1 | C1-1 | C2-1 | 80/20 | 15.5 | 0.125 | 0.2 | A |
| Example 15 | A-14 | B-25 | D-1 | W-2 | C1-1 | C2-2/C2-5 | 70/20/10 | 14.5 | 0.125 | 0.1 | A |
| Example 16 | A-14 | B-1 | D-1 | W-1 | C1-2 | C2-4 | 50/50 | 15.5 | 0.125 | 0.4 | A |
| Example 17 | A-20 | B-1 | D-1 | W-1 | C1-2 | C2-2 | 80120 | 15.5 | 0.125 | 0.8 | B |
| Example 18 | A-20 | B-58 | D-1 | W-2 | C1-1 | C2-6 | 70130 | 17.0 | 0.130 | 0.6 | B |
| Example 19 | A-22 | B-1 | D-1 | W-1 | C1-1 | C2-2 | 90110 | 14.0 | 0.130 | 0.1 | A |
| Example 20 | A-22 | B-1 | D-1 | W-2 | C1-2 | C2-8 | 30/70 | 14.5 | 0.130 | 0.9 | B |
| Example 21 | A-26 | B-1 | D-1 | W-1 | C1-1 | C2-2 | 70/30 | 14.0 | 0.130 | 0.4 | A |
| Example 22 | A-26 | B-1 | D-1 | W-1 | C1-2 | C2-1 | 60/40 | 14.5 | 0.130 | 0.6 | B |
| Example 23 | A-26 | B-25 | D-1 | W-2 | C1-1 | C2-1/C2-2 | 70/20/10 | 13.5 | 0.125 | 0.6 | B |
| Example 24 | A-40 | B-1 | D-1 | W-1 | C1-1 | C2-2 | 70/30 | 16.0 | 0.125 | 0.2 | A |
| Example 25 | A-40 | B-1 | D-1 | W-1 | C1-2 | C2-3 | 70/30 | 16.5 | 0.125 | 0.4 | A |
| Example 26 | A-40 | B-58 | D-1 | W-2 | C1-1 | C2-1 | 60/40 | 16.5 | 0.120 | 0.1 | A |
| Example 27 | A-40 | B-1 | D-1 | W-2 | C1-1 | C2-1/C2-5 | 70/20/10 | 16.5 | 0.120 | 0.2 | A |
| Example 28 | A-40 | B-1 | D-1 | W-2 | C1-1 | C2-9 | 60/40 | 16.5 | 0.120 | 0.4 | A |
| Comparative Example 1 | R-7 | B-1 | D-1 | W-1 | C1-1 | C2-1 | 70/30 | 25.0 | 0.150 | 14.7 | C |
| Comparative Example 2 | R-7 | B-1 | D-1 | W-1 | C1-1 | C2-5 | 70/30 | 25.0 | 0.150 | 17.9 | C |
| Comparative Example 3 | R-18 | B-31 | D-1 | W-1 | C1-1 | C2-2 | 70/30 | 28.0 | 0.155 | 15.2 | C |
| Comparative Example 4 | R-18 | B-1 | D-1 | W-2 | G1-1 | C2-2 | 50/50 | 29.0 | 0.155 | 19.0 | C |
| Comparative Example 5 | R-18 | B-1 | D-1 | W-1 | C2-2 | C2-9 | 60/40 | 29.5 | 0.155 | 21.0 | C |

It is seen from Table 4 that as regards the pattern formation by the KrF excimer laser exposure, the positive resist composition of the present invention is assured of high sensitivity, high resolving power and superior coatability and excellent in terms of development defect, as compared with the case using the compounds of Comparative Examples.

### [Production and Evaluation of Pattern (EB)]

The components shown in Table 5 were dissolved, and the obtained solution was microfiltered through a membrane filter having a pore size of 0.1 µm to obtain a resist solution.

This resist solution was coated on a hexamethyldisilazane-treated silicon wafer by using a spin coater, Mark 8, manufactured by Tokyo Electron Ltd. and then baked at 120°C for 60 seconds to obtain a film having an average thickness of 300 nm.

The resist film formed was then irradiated with electron beams by using an electron beam image-drawing apparatus (HL750, manufactured by Hitachi Ltd., accelerating voltage: 50 KeV). After the irradiation, the resist film was baked at 130°C for 60 seconds, dipped in an aqueous 2.38 mass% tetramethylammonium hydroxide (TMAH) solution for 60 seconds, rinsed with water for 30 seconds and dried. The obtained pattern was evaluated by the following methods.

### (Sensitivity)

The line width of the obtained pattern was observed by a scanning electron microscope (S-9260, manufactured by Hitachi, Ltd.), and the irradiation energy when resolving a 0.15-µm line (line:space = 1:1) was defined as the sensitivity.

### (Resolving Power)

To what µm the pattern of line:space=1:1 was resolved with the irradiation energy giving the sensitivity obtained above was observed by the same scanning electron microscope.

### (Development Defect)

A 0.15-µm pattern at line:space=1:1 was formed by irradiating electron means with the irradiation energy giving the sensitivity obtained above and performing the baking and development in the same manner as above, and the number of development defects was observed by the same scanning electron microscope at 100 portions in an area of 3 µm (width) × 3 µm (length) and rated A when the value obtained was less than 3, rated B when from 3 to less than 10, and rated C when 10 or more.

**Table 5**

| | Resin (0.966 g) | Acid Generator (003 g) | Organic Basic Compound | Surfactant (0.001 g) | Solvent (14 g) | | | Sensitivity (µC/cm²) | Resolving Power (µm) | Development Defect | |
|---|---|---|---|---|---|---|---|---|---|---|---|
| | | | | | A | B | Ratio | | | Number of Defects (defects) | Rating |
| Example 29 | A-1 | B-1 | D-1 | W-1 | C1-1 | C2-1 | 70/30 | 8 | 0.08 | 0 | A |
| Example 30 | A-1 | B-1 | D-1 | W-1 | C1-1 | C2-2 | 70/30 | 8 | 0.08 | 0 | A |
| Example 31 | A-1 | B-1 | D-1 | W-1 | G1-1 | C2-3 | 70130 | 8 | 0.08 | 0 | A |
| Example 32 | A-1 | 8-1 | D-1 | W-1 | C1-1 | C2-4 | 70/30 | 8 | 0.08 | 0 | A |
| Example 33 | A-1 | 8-1 | D-1 | W-1 | C1-1 | C2-5 | 70/30 | 8 | 0.08 | 1 | A |
| Example 34 | A-2 | B-1 | D-1 | W-1 | C1-2 | C2-1 | 80/20 | 7 | 0.1 | 5 | B |
| Example 35 | A-2 | B-31 | D-1 | W-2 | C1-1 | C2-2 | 80/20 | 6.5 | 0.1 | 1 | A |
| Example 36 | A-5 | B-1 | D-1 | W-1 | C1-1 | C2-1 | 70/30 | 7.5 | 0.09 | 0 | A |
| Example 37 | A5 | B-1 | D-1 | W-2 | C1-2 | C2-4 | 70/30 | 8 | 0.09 | 2 | A |
| Example 38 | A-5 | B-58 | D-1 | W-1 | C1-1 | C2-1/C2-5 | 70/20/10 | 8.5 | 0.09 | 1 | A |
| Example 39 | A-5 | B-1 | D-1 | W-1 | C1-3 | C2-6 | 70/30 | 7.5 | 0.09 | 2 | A |
| Example 40 | A-7 | B-1 | D-1 | W-1 | C1-1 | C2-1 | 60/40 | 7 | 0.08 | 1 | A |
| Example 41 | A-7 | B-31 | D-1 | W-2 | C1-1 | C2-7 | 30/70 | 7 | 0.08 | 4 | B |
| Example 42 | A-14 | B-1 | D-1 | W-1 | C1-1 | C2-1 | 80/20 | 8 | 0.08 | 0 | A |
| Example 43 | A-14 | B-25 | D-1 | W-2 | C1-1 | C2-2/C2-5 | 70/20/10 | 7 | 0.08 | 0 | A |
| Example 44 | A-14 | B-1 | D-1 | W-1 | C1-2 | C2-4 | 50/50 | 7 | 0.08 | 1 | A |
| Example 45 | A-20 | B-1 | D-1 | W-1 | C1-2 | C2-2 | 80/20 | 7 | 0.08 | 3 | B |
| Example 46 | A-20 | B-58 | D-1 | W-2 | C1-1 | C2-6 | 70/30 | 8 | 0.09 | 9 | B |
| Example 47 | A-22 | B-1 | D-1 | W-1 | G1-1 | C2-2 | 90/10 | 6 | 0.1 | 1 | A |
| Example 48 | A-22 | B-1 | D-1 | W-2 | C1-2 | C2-8 | 30/70 | 7 | 0.1 | 8 | B |
| Example 49 | A-26 | 8-1 | D-1 | W-1 | C1-1 | C2-2 | 70/30 | 7 | 0.1 | 1 | A |
| Example 50 | A-26 | B-1 | D-1 | W-1 | C1-2 | C2-1 | 60/40 | 7 | 0.1 | 2 | A |
| Example 51 | A-26 | B-25 | D-1 | W-2 | C1-1 | C2-1/C2-2 | 70/20/10 | 7 | 0.1 | 2 | A |
| Example 52 | A-40 | B-1 | D-1 | W-1 | C1-1 | C2-2 | 70/30 | 9 | 0.08 | 0 | A |
| Example 53 | A-40 | B-1 | D-1 | W-1 | C1-2 | C2-3 | 70/30 | 9 | 0.08 | 1 | A |
| Example 54 | A-40 | B-58 | D-1 | W-2 | C1-1 | C2-1 | 60/40 | 8.5 | 0.08 | 0 | A |
| Example 55 | A-40 | B-1 | D-1 | W-2 | C1-1 | C2-1/C2-5 | 70/20/10 | 8.5 | 0.08 | 0 | A |
| Example 56 | A-40 | B-1 | D-1 | W-2 | C1-1 | C2-9 | 60/40 | 8.5 | 0.08 | 0 | A |
| Comparative Example 6 | R-7 | B-1 | D-1 | W-1 | C1-1 | C2-1 | 70/30 | 12 | 0.13 | 25 | C |
| Comparative Example 7 | R-7 | B-1 | D-1 | W-1 | C1-1 | C2-5 | 70/30 | 15 | 0.13 | 18 | C |
| Comparative Example 8 | R-18 | B-31 | D-1 | W-1 | C1-1 | C2-2 | 70/30 | 14 | 0.14 | 30 | C |
| Comparative Example 9 | R-18 | B-1 | D-1 | W-2 | C1-1 | C2-2 | 50/50 | 14 | 0.14 | 42 | C |
| Comparative Example 10 | R-18 | B-1 | D-1 | W-1 | C2-2 | C2-9 | 60/40 | 14 | 0.14 | 32 | C |

It is seen from Table 5 that as regards the pattern formation by the irradiation with electron beams, the resist composition of the present invention is assured of high sensitivity and high resolving power and excellent in terms of a small number of development defects, as compared with the case using the compounds of Comparative Examples.

### [Production and Evaluation of Pattern (EUV)]

The components shown in Table 6 were dissolved, and the obtained solution was microfiltered through a membrane filter having a pore size of 0.1 µm to obtain a resist solution.

This resist solution was coated on a hexamethyldisilazane-treated silicon wafer by using a spin coater, Mark 8, manufactured by Tokyo Electron Ltd. and then baked at 120°C for 60 seconds to obtain a film having an average thickness of 150 nm.

The resist film formed was exposed using EUV light (wavelength: 13 nm, EUVES, manufactured by Litho Tech Japan Co., Ltd.) by changing the exposure amount in steps of 0.5 mJ in the range from 0 to 20.0 mJ and then baked at 130°C for 90 seconds. Thereafter, the dissolution rate at each exposure amount was measured using an aqueous 2.38 mass% tetramethylammonium hydroxide (TMAH) solution to obtain a sensitivity curve.

### (Sensitivity and Resolving Power (Dissolution Contrast))

The exposure amount when the dissolution rate of the resist was saturated in the sensitivity curve above was defined as the sensitivity and also, the dissolution contrast (y value) as an index for the resolving power was calculated from the gradient in the straight line part of the sensitivity curve. As the γ value is larger, the dissolution contrast is more excellent and the resolving power is higher.

### (Development Defect)

Exposure with an exposure amount giving the sensitivity above and the same baking and development as above were performed, and the number of defects was observed by the same scanning electron microscope at 100 portions in an area of 3 µm (width) x 3 µm (length) at the boundary between the exposed part and the unexposed part and rated A when the value obtained was less than 3, rated B when from 3 to less than 10, and rated C when 10 or more.

**Table 6**

| | Resin (0.966 g) | Acid Generator (0.03 g) | Organic Basic Compound (0.003 g) | Surfactant (0.001 g) | Solvent (14g) | | | Sensitivity (mJ/cm²) | Resolving Power (γ value) | Development Defect | |
|---|---|---|---|---|---|---|---|---|---|---|---|
| | | | | | A | B | Ratio | | | Number of Defects (defects) | Rating |
| Example 57 | A-1 | B-1 | D-1 | W-1 | C1-1 | C2-1 | 70130 | 6 | 6.3 | 1 | A |
| Example 58 | A-1 | B-1 | D-1 | W-1 | C1-1 | G2-2 | 70/30 | 6 | 6.4 | 0 | A |
| Example 59 | A-1 | B-1 | D-1 | W-1 | C1-1 | C2-3 | 70/30 | 6 | 6.2 | 0 | A |
| Example 60 | A-14 | B-1 | D-1 | W-1 | C1-1 | C2-1 | 80/20 | 6 | 6.7 | 0 | A |
| Example 61 | A-14 | B-25 | D-1 | W-2 | C1-1 | C2-2/C2-5 | 70/20/10 | 6 | 6.8 | 0 | A |
| Example 62 | A-14 | B-1 | D-1 | W-1 | C1-2 | C2-4 | 50/50 | 6 | 6.7 | 3 | B |
| Example 63 | A-40 | B-1 | D-1 | W-1 | C1-1 | C2-2 | 70/30 | 7 | 6.6 | 0 | A |
| Example 64 | A-40 | B-1 | D-1 | W-1 | C1-2 | C2-3 | 70/30 | 7 | 6.4 | 2 | A |
| | | | | | | | | | | | |
| Comparative Example 11 | R-7 | B-1 | D-1 | W-1 | C1-1 | C2-1 | 70/30 | 13 | 4.3 | 40 | C |

It is seen from Table 6 that as regards the pattern formation by the EUV exposure, the positive resist composition of the present invention is assured of high sensitivity and high dissolution contrast and excellent in terms of a small number of development defects, as compared with the case using the compound of Comparative Example.

As verified above, the positive resist composition of the present invention could form a good pattern by both the electron beam irradiation and the EUV irradiation.

According to the present invention, as regards the pattern formation by the irradiation of electron beam, KrF excimer laser light, EUV light or the like, a positive resist composition assured of high resolution and high sensitivity and excellent in the improvement of development defect, and a pattern forming method using the composition can be provided.

The entire disclosure of each and every foreign patent application from which the benefit of foreign priority has been claimed in the present application is incorporated herein by reference, as if fully set forth.

## Claims

1. A resist composition, which comprises:
(A) a resin containing a repeating unit represented by formula (I);
(B) a compound capable of generating an acid upon irradiation with actinic rays or radiation; and
(C) a solvent containing: (C1) a propylene glycol monoalkyl ether carboxylate; and (C2) at least one member selected from the group consisting of a propylene glycol monoalkyl ether, an alkyl lactate, an acetic acid ester, an alkyl alkoxypropionate, a chain ketone and a cyclic ketone: 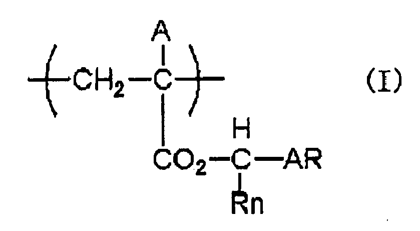
wherein AR represents a substituted or unsubstituted benzene ring or a substituted or unsubstituted naphthalene ring;
Rn represents a substituted or unsubstituted alkyl group, a substituted or unsubstituted cycloalkyl group or a substituted or unsubstituted aryl group; and
A represents a hydrogen atom, a substituted or unsubstituted alkyl group, a substituted or unsubstituted cycloalkyl group, a halogen atom, a cyano group or a substituted or unsubstituted alkyloxycarbonyl group.

2. The resist composition according to claim 1,
wherein the solvent (C1) is at least one member selected from the group consisting of propylene glycol monomethyl ether acetate, propylene glycol monomethyl ether propionate and propylene glycol monoethyl ether acetate.

3. The resist composition according to claim 1,
wherein the solvent (C2) is at least one member selected from the group consisting of propylene glycol monomethyl ether, ethyl lactate, methoxymethyl propionate, ethoxyethyl propionate, methyl amyl ketone, cyclohexanone, γ-butyrolactone and propylene carbonate.

4. The resist composition according to claim 1,
wherein a ratio by mass of the solvents (C1)/(C2) is from 15/85 to 90/10.

5. The resist composition according to claim 1,
wherein the resin (A) further contains a repeating unit represented by formula (A1): 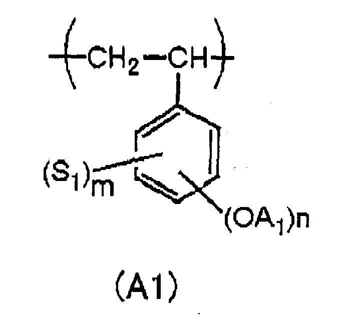 wherein n represents an integer of 0 to 3;
m represents an integer of 0 to 3, provided that m+n≤5;
A₁ represents a hydrogen atom or a group containing a group capable of decomposing under an action of an acid; and
S₁ represents a substituent, and when a plurality of S₁'s are present, the plurality of S₁'s may be the same or different.

6. The resist composition according to claim 5,
wherein in the repeating unit represented by formula (A1), the group containing a group capable of decomposing under an action of an acid represented by A₁ is an acetal group or a ketal group.

7. The resist composition according to claim 1,
wherein AR represents a benzene or a p-methylbenzene.

8. A pattern forming method, which comprises:
forming a resist film from the resist composition according to claim 1; and
exposing and developing the resist film.
